(19) Europäisches Patentamt
European Patent Office
Office européen des brevets

(11) EP 4 209 555 A1

(12) **EUROPEAN PATENT APPLICATION**
published in accordance with Art. 153(4) EPC

(43) Date of publication:
**12.07.2023 Bulletin 2023/28**

(21) Application number: **21864109.0**

(22) Date of filing: **18.08.2021**

(51) International Patent Classification (IPC):
***C09B 47/08*** (2006.01) ***C09D 4/00*** (2006.01)
***G03F 7/004*** (2006.01) ***G02B 5/20*** (2006.01)
***C09D 7/41*** (2018.01) ***C09B 67/20*** (2006.01)

(52) Cooperative Patent Classification (CPC):
**C09B 47/08; C09B 67/006; C09D 4/00; C09D 7/41; G02B 5/20; G03F 7/004**

(86) International application number:
**PCT/JP2021/030239**

(87) International publication number:
**WO 2022/050051 (10.03.2022 Gazette 2022/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **01.09.2020 JP 2020147098**

(71) Applicant: **SUMITOMO CHEMICAL COMPANY, LIMITED**
**Tokyo 103-6020 (JP)**

(72) Inventors:
- **AOKI, Takuma**
  **Osaka-shi, Osaka 554-8558 (JP)**
- **NAKAYAMA, Tomohiro**
  **Osaka-shi, Osaka 554-8558 (JP)**
- **AKASAKA, Tetsuo**
  **Osaka-shi, Osaka 554-8558 (JP)**
- **KUROGI, Takahiro**
  **Osaka-shi, Osaka 554-8558 (JP)**

(74) Representative: **Vossius & Partner Patentanwälte Rechtsanwälte mbB**
**Siebertstraße 3**
**81675 München (DE)**

(54) **COMPOUND**

(57) The present invention provides a novel compound represented by formula (I) or formula (II) capable of reducing the color difference before and after post-baking.

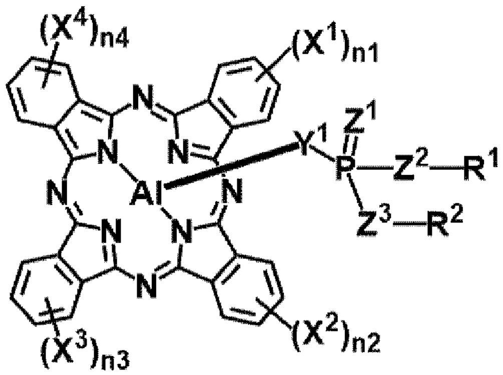

(I)



Processed by Luminess, 75001 PARIS (FR)

(Cont. next page)

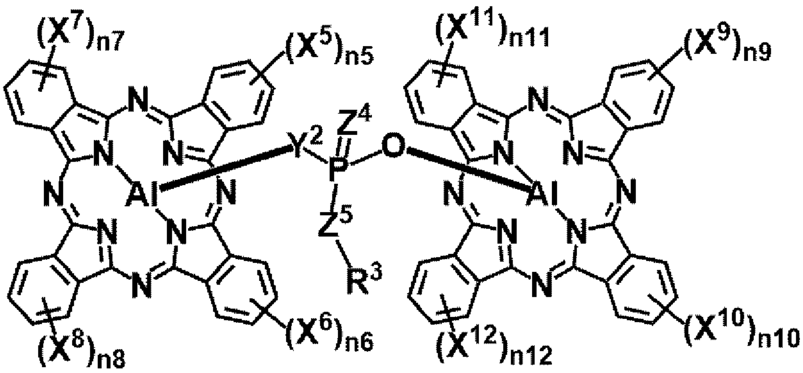

(II)

[In the formula (I), $Y^1$ and $Z^1$ each independently represent an oxygen atom or a sulfur atom, and $Z^2$ and $Z^3$ each independently represent a single bond, an oxygen atom, or a sulfur atom, provided that at least one of $Y^1$, $Z^1$, $Z^2$, and $Z^3$ represents a sulfur atom, and in the formula (II), Y2 and Z4 each independently represent an oxygen atom or a sulfur atom, and Z5 represents a single bond, an oxygen atom, or a sulfur atom, provided that at least one of Y2, Z4, and Z5 represents a sulfur atom.]

## Description

### TECHNICAL FIELD

The present invention relates to a compound, a colored resin composition, a color filter, and a display device.

### BACKGROUND ART

An optical filter used for display devices such as a liquid crystal display device, an electroluminescence display device, and a plasma display, and solid-state image sensors such as a CCD and a CMOS sensor is produced from a colored resin composition. An aluminum phthalocyanine pigment is known as a colorant for such a colored resin composition. Patent Document 1 discloses that using an aluminum phthalocyanine pigment having a specific structure as a colorant provides a colored composition for a color filter that is excellent in not only NMP (N-methylpyrrolidone) resistance but also developability and flatness of a coating film while having high brightness.

### PRIOR ART DOCUMENT

### PATENT DOCUMENT

Patent Document 1: JP 2016-75837 (A)

### SUMMARY OF THE INVENTION

### PROBLEMS TO BE SOLVED BY THE INVENTION

However, the use of the aluminum phthalocyanine pigment disclosed in Patent Document 1 sometimes caused a large color difference before and after post-baking. An object of the present invention is to provide a novel compound capable of reducing the color difference before and after post-baking.

### SOLUTIONS TO THE PROBLEMS

The present invention includes the following inventions.

[1] A compound represented by formula (I) or formula (II):

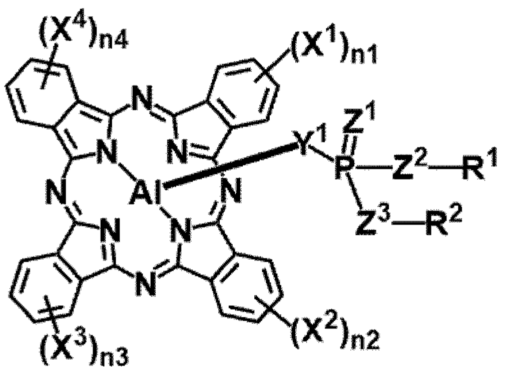

(I)

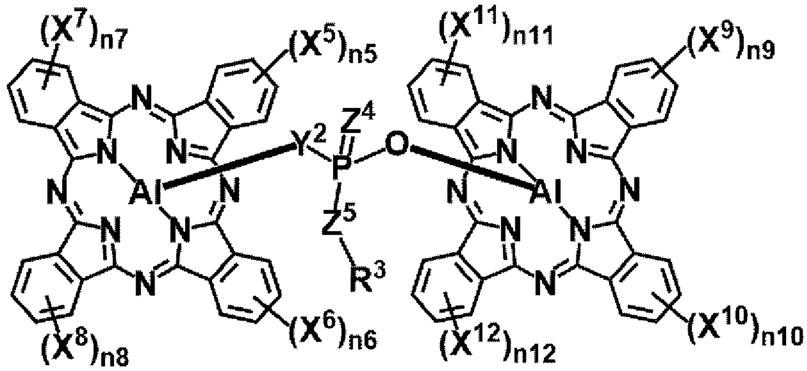

(II)

wherein in the formula (I),

$R^1$ represents a hydrogen atom or a hydrocarbon group having 1 to 20 carbon atoms and optionally having a substituent;
$R^2$ represents a hydrogen atom, a hydrocarbon group having 1 to 20 carbon atoms and optionally having a substituent, or a single bond connecting $Z^3$ and $R^1$;
$Y^1$ and $Z^1$ each independently represent an oxygen atom or a sulfur atom, and $Z^2$ and $Z^3$ each independently represent a single bond, an oxygen atom, or a sulfur atom, provided that at least one of $Y^1$, $Z^1$, $Z^2$, and $Z^3$ represents a sulfur atom;
$X^1$ to $X^4$ each independently represent $-R^4$, $-OR^4$, $-SR^4$, a halogen atom, a nitro group, or a sulfamoyl group optionally having a substituent;
$R^4$ represents a hydrocarbon group having 1 to 20 carbon atoms and optionally having a substituent; and
n1 to n4 each independently represent an integer of 0 to 4, and
in the formula (II),
$R^3$ represents a hydrogen atom or a hydrocarbon group having 1 to 20 carbon atoms and optionally having a substituent;
$Y^2$ and $Z^4$ each independently represent an oxygen atom or a sulfur atom, and $Z^5$ represents a single bond, an oxygen atom, or a sulfur atom, provided that at least one of $Y^2$, $Z^4$, and $Z^5$ represents a sulfur atom;
$X^5$ to $X^{12}$ each independently represent $-R^5$, $-OR^5$, $-SR^5$, a halogen atom, a nitro group, or a sulfamoyl group optionally having a substituent;
$R^5$ represents a hydrocarbon group having 1 to 20 carbon atoms and optionally having a substituent; and
n5 to n12 each independently represent an integer of 0 to 4.

[2] A colored resin composition comprising the compound according to [1] and a resin.
[3] The colored resin composition according to [2], comprising a polymerizable compound and a polymerization initiator.
[4] A color filter formed from the colored resin composition according to [2] or [3].
[5] A display device comprising the color filter according to [4].

EFFECT OF THE INVENTION

A color filter formed from a colored resin composition containing a novel compound of the present invention can have a reduced color difference before and after post-baking.

MODE FOR CARRYING OUT THE INVENTION

<<Compound>>

Hereinafter, the present invention will be described more specifically with reference to a partial structure of the compound represented by formula (I) or formula (II). A color filter formed from a colored resin composition containing the novel compound represented by formula (I) or formula (II) of the present invention can have a reduced color difference before and after post-baking. Furthermore, in one embodiment of the present invention, a colored resin composition containing the novel compound can have a reduced change in transmittance at 500 to 650 nm before and after post-baking. The compound represented by formula (I) includes a compound represented by formula (Ia), which has a resonance structure, or a compound represented by formula (Ib), which is in chemical equilibrium with the compound

represented by formula (I). The compound represented by formula (II) includes a compound represented by formula (IIa), which has a resonance structure, or a compound represented by formula (IIb), which is in chemical equilibrium with the compound represented by formula (II).

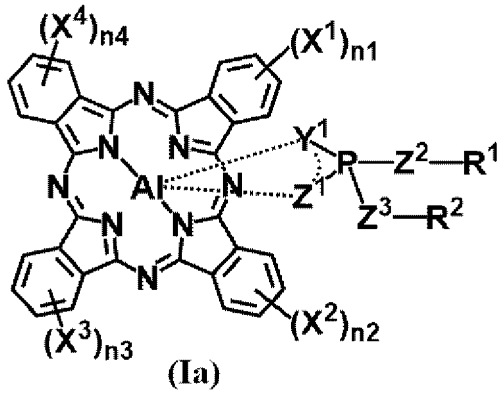

(Ia)

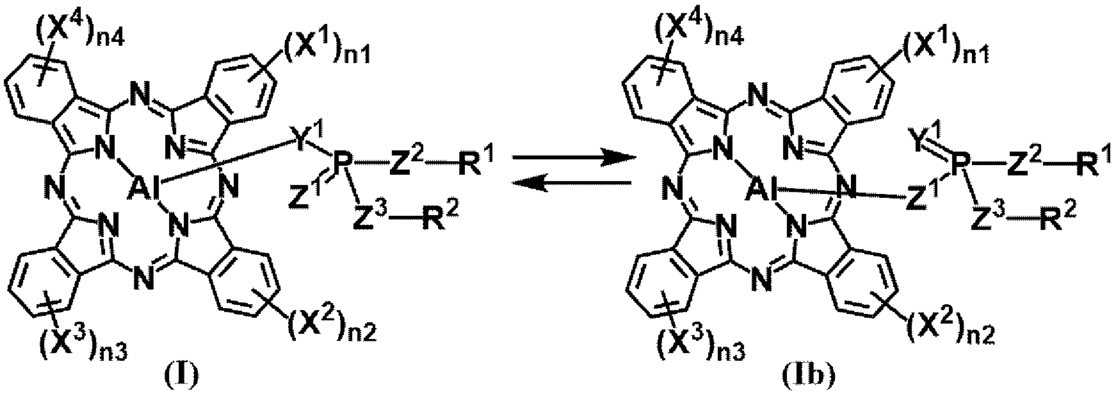

(I) (Ib)

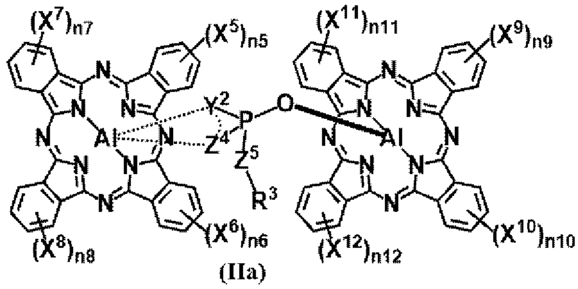

(IIa)

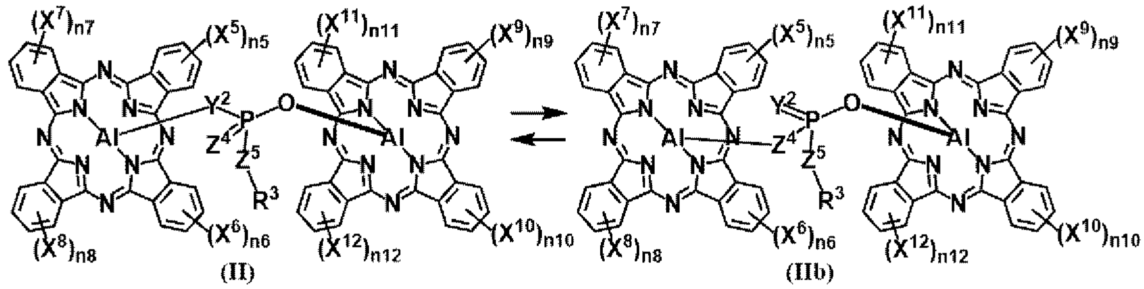

(II) (IIb)

[In the formulas (I), (Ia) and (Ib),

$R^1$ represents a hydrogen atom or a hydrocarbon group having 1 to 20 carbon atoms and optionally having a substituent;

$R^2$ represents a hydrogen atom, a hydrocarbon group having 1 to 20 carbon atoms and optionally having a substituent, or a single bond connecting $Z^3$ and $R^1$;

$Y^1$ and $Z^1$ each independently represent an oxygen atom or a sulfur atom, and $Z^2$ and $Z^3$ each independently represent a single bond, an oxygen atom, or a sulfur atom, provided that at least one of $Y^1$, $Z^1$, $Z^2$, and $Z^3$ represents a sulfur atom;

$X^1$ to $X^4$ each independently represent $-R^4$, $-OR^4$, $-SR^4$, a halogen atom, a nitro group, or a sulfamoyl group optionally having a substituent;

$R^4$ represents a hydrocarbon group having 1 to 20 carbon atoms and optionally having a substituent; and

n1 to n4 each independently represent an integer of 0 to 4.

In the formulas (II), (IIa) and (IIb),

$R^3$ represents a hydrogen atom or a hydrocarbon group having 1 to 20 carbon atoms and optionally having a substituent;

$Y^2$ and $Z^4$ each independently represent an oxygen atom or a sulfur atom, and $Z^5$ represents a single bond, an oxygen atom, or a sulfur atom, provided that at least one of $Y^2$, $Z^4$, and $Z^5$ represents a sulfur atom;

$X^5$ to $X^{12}$ each independently represent $-R^5$, $-OR^5$, $-SR^5$, a halogen atom, a nitro group, or a sulfamoyl group optionally having a substituent;

$R^5$ represents a hydrocarbon group having 1 to 20 carbon atoms and optionally having a substituent; and

n5 to n12 each independently represent an integer of 0 to 4.]

The C1-C20 hydrocarbon group represented by $R^1$ to $R^5$ may be an aliphatic hydrocarbon group or an aromatic hydrocarbon group. The aliphatic hydrocarbon group may be saturated or unsaturated, and may be chain or cyclic (alicyclic hydrocarbon group).

Examples of the saturated or unsaturated chain hydrocarbon group represented by $R^1$ to $R^5$ include straight-chain alkyl groups such as methyl, ethyl, propyl, butyl, pentyl, hexyl, heptyl, octyl, nonyl, decyl, undecyl, dodecyl, tridecyl, tetradecyl, pentadecyl, hexadecyl, heptadecyl, octadecyl, nonadecyl, and icosyl;

branched-chain alkyl groups such as isopropyl, isobutyl, sec-butyl, tert-butyl, 2-ethylbutyl, 3,3-dimethylbutyl, 1,1,3,3-tetramethylbutyl, 1-methylbutyl, 1-ethylpropyl, 3-methylbutyl, neopentyl, 1,1-dimethylpropyl, 2-methylpentyl, 3-ethylpentyl, 1,3-dimethylbutyl, 2-propylpentyl, 1-ethyl-1,2-dimethylpropyl, 1-methylpentyl, 4-methylpentyl, 4-methylhexyl, 5-methylhexyl, 2-ethylhexyl, 1-methylhexyl, 1-ethylpentyl, 1-propylbutyl, 3-ethylheptyl, 2,2-dimethylheptyl, 1-methylheptyl, 1-ethylhexyl, 1-propylpentyl, 1-methyloctyl, 1-ethylheptyl, 1-propylhexyl, 1-butylpentyl, 1-methylnonyl, 1-ethyloctyl, 1-propylheptyl, and 1-butylhexyl;

alkenyl groups such as ethenyl (vinyl), propenyl (for example, 1-propenyl and 2-propenyl (allyl)), 1-methylethenyl, butenyl (for example, 1-butenyl, 2-butenyl, and 3-butenyl), 3-methyl-1-butenyl, 1-methyl-1-butenyl, 3-methyl-2-butenyl, 1,3-butadienyl, 3-methyl-1,2-butadienyl, 1-(2-propenyl)ethenyl, 1-(1-methylethenyl)ethenyl, 1,1-dimethyl-2-propenyl, 1,2-dimethyl-1-propenyl, 1-ethyl-2-propenyl, pentenyl (for example, 1-pentenyl, 2-pentenyl, 3-pentenyl, and 4-pentenyl), 1-(1,1-dimethylethyl)ethenyl, 1,3-dimethyl-1-butenyl, hexenyl (for example, 1-hexenyl and 5-hexenyl), heptenyl (for example, 1-heptenyl and 6-heptenyl), octenyl (for example, 1-octenyl and 7-octenyl), nonenyl (for example, 1-nonenyl and 8-nonenyl), decenyl (for example, 1-decenyl and 9-decenyl), undecenyl, dodecenyl, tridecenyl, tetradecenyl, pentadecenyl, hexadecenyl, heptadecenyl, octadecenyl, nonadecenyl, and icosenyl; and

alkynyl groups such as ethynyl, propynyl (for example, 1-propynyl and 2-propynyl), butynyl (for example, 1-butynyl, 2-butynyl, and 3-butynyl), pentynyl, hexynyl, heptynyl, octynyl (for example, 1-octynyl, and 7-octynyl), nonynyl, decynyl, undecynyl, dodecynyl, tridecynyl, tetradecynyl, pentadecynyl, hexadecynyl, heptadecynyl, octadecynyl, nonadecynyl, and icosynyl.

The saturated chain hydrocarbon group (namely, straight-chain alkyl group and branched-chain alkyl group) represented by $R^1$ to $R^5$ preferably has 1 to 10 carbon atoms, more preferably 1 to 7 carbon atoms, and still more preferably 1 to 5 carbon atoms.

The unsaturated chain hydrocarbon group (namely, alkenyl group and alkynyl group) represented by $R^1$ to $R^5$ preferably has 2 to 10 carbon atoms, more preferably 2 to 7 carbon atoms, and still more preferably 2 to 5 carbon atoms.

Examples of the saturated or unsaturated alicyclic hydrocarbon group represented by $R^1$ to $R^5$ include cycloalkyl groups such as cyclopropyl, 1-methylcyclopropyl, cyclobutyl, cyclopentyl, cyclohexyl, cycloheptyl, 1-methylcyclohexyl, 2-methylcyclohexyl, 3-methylcyclohexyl, 4-methylcyclohexyl, 1,2-dimethylcyclohexyl, 1,3-dimethylcyclohexyl, 1,4-dimethylcyclohexyl, 2,3-dimethylcyclohexyl, 2,4-dimethylcyclohexyl, 2,5-dimethylcyclohexyl, 2,6-dimethylcyclohexyl, 3,4-dimethylcyclohexyl, 3,5-dimethylcyclohexyl, 2,2-dimethylcyclohexyl, 3,3-dimethylcyclohexyl, 4,4-dimethylcyclohexyl, cyclooctyl, 2,4,6-trimethylcyclohexyl, 2,2,6,6-tetramethylcyclohexyl, 3,3,5,5-tetramethylcyclohexyl, 4-pentylcyclohexyl, 4-octylcyclohexyl, and 4-cyclohexylcyclohexyl;

cycloalkenyl groups such as cyclohexenyl (for example, cyclohex-1-en-1-yl, cyclohex-2-en-1-yl, and cyclohex-3-en-1-yl), cycloheptenyl, and cyclooctenyl; and
saturated or unsaturated polycyclic hydrocarbon groups such as norbornyl, norbornenyl, adamantly, and bicyclo[2.2.2]octyl.

The saturated or unsaturated alicyclic hydrocarbon group represented by $R^1$ to $R^5$ preferably has 3 to 10 carbon atoms.
Examples of the aromatic hydrocarbon group represented by $R^1$ to $R^5$ include phenyl, o-tolyl, m-tolyl, p-tolyl, 2-ethylphenyl, 3-ethylphenyl, 4-ethylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 4-vinylphenyl, o-isopropylphenyl, m-isopropylphenyl, p-isopropylphenyl, o-tert-butylphenyl, m-tert-butylphenyl, p-tert-butylphenyl, 3,5-di(tert-butyl)phenyl, 3,5-di(tert-butyl)-4-methylphenyl, 4-butylphenyl, 4-pentylphenyl, 2,6-bis(1-methylethyl)phenyl, 2,4,6-tris(1-methylethyl)phenyl, 4-cyclohexylphenyl, 2,4,6-trimethylphenyl, 4-octylphenyl, 4-(1,1,3,3-tetramethylbutyl)phenyl, 1-naphthyl, 2-naphthyl, 6-methyl-2-naphthyl, 5,6,7,8-tetrahydro-1-naphthyl, 5,6,7,8-tetrahydro-2-naphthyl, fluorenyl, phenanthryl, anthryl, 2-dodecylphenyl, 3-dodecylphenyl, 4-dodecylphenyl, perylenyl, chrysenyl, and pyrenyl.
The aromatic hydrocarbon group represented by $R^1$ to $R^5$ preferably has 6 to 20 carbon atoms, more preferably 6 to 10 carbon atoms, and still more preferably 6 to 8 carbon atoms.
The hydrocarbon group represented by $R^1$ to $R^5$ may be a group in which the above-mentioned hydrocarbon groups (for example, an aromatic hydrocarbon group and at least one of a chain hydrocarbon group and an alicyclic hydrocarbon group) are combined. Examples of thereof include aralkyl groups such as benzyl, (2-methylphenyl)methyl, (3-methylphenyl)methyl, (4-methylphenyl)methyl, (2-ethylphenyl)methyl, (3-ethylphenyl)methyl, (4-ethylphenyl)methyl, (2-(tert-butyl)phenyl)methyl, (3-(tert-butyl)phenyl)methyl, (4-(tert-butyl)phenyl)methyl, (3,5-dimethylphenyl)methyl, 1-phenylethyl, 1-methyl-1-phenylethyl, 1,1-diphenylethyl, (1-naphthyl)methyl, and (2-naphthyl)methyl;

arylalkenyl groups such as 1-phenylethenyl, 2-phenylethenyl (phenylvinyl), 2,2-diphenylethenyl, and 2-phenyl-2-(1-naphthyl)ethenyl;
arylalkynyl groups such as phenylethynyl;
phenyl groups with one or more phenyl groups bonded, such as biphenylyl and terphenylyl; and
cyclohexylmethylphenyl, benzylphenyl, and (dimethyl(phenyl)methyl)phenyl.

This group preferably has 7 to 18 carbon atoms, and more preferably 7 to 15 carbon atoms.
The group represented by $R^1$ to $R^5$ may also be a group in which the above-mentioned hydrocarbon groups (for example, a chain hydrocarbon group and an alicyclic hydrocarbon group) are combined. Examples of thereof include alkyl groups with one or more alicyclic hydrocarbon groups bonded, such as cyclopropylmethyl, cyclopropylethyl, cyclobutylmethyl, cyclobutylethyl, cyclopentylmethyl, cyclopentylethyl, cyclohexylmethyl, (2-methylcyclohexyl)methyl, cyclohexylethyl, and adamantylmethyl.
This group preferably has 4 to 15 carbon atoms, and more preferably 4 to 10 carbon atoms.
The C1-C20 hydrocarbon group represented by $R^1$ to $R^5$ optionally has a substituent.
Examples of the substituent include a heterocyclic group optionally having a substituent, a halogen atom, a nitro group, a cyano group, $-OR^{a1}$, $-CO_2R^{a1}$, $-SR^{a1}$, $-SO_2R^{a1}$, $-SO_3R^{a1}$, $-SO_2NR^{a1}R^{a2}$, and $-NR^{a1}R^{a2}$.
$R^{a1}$ and $R^{a2}$ each independently represent a hydrogen atom or a hydrocarbon group having 1 to 20 carbon atoms. The C1-C20 hydrocarbon group represented by $R^{a1}$ and $R^{a2}$ is the same as the C1-C20 hydrocarbon group represented by $R^1$ to $R^5$ described above.
The heterocyclic group used as the substituent of the C1-C20 hydrocarbon group represented by $R^1$ to $R^5$ may be monocyclic or polycyclic, and is preferably a heterocycle containing a heteroatom as a constituent element of its ring. Examples of the heteroatom include a nitrogen atom, an oxygen atom, and a sulfur atom.
Examples of a heterocycle containing only nitrogen atom(s) as the heteroatom include monocyclic saturated heterocycles such as aziridine, azetidine, pyrrolidine, piperidine, and piperazine; 5-membered unsaturated heterocycles such as pyrrole, pyrazole, imidazole, 1,2,3-triazole, and 1,2,4-triazole; 6-membered unsaturated heterocycles such as pyridine, pyridazine, pyrimidine, pyrazine, and 1,3,5-triazine; fused bicyclic heterocycles such as indazole, indoline, isoindoline, isoindoline-1,3-dione, indole, indolizine, benzimidazole, quinoline, isoquinoline, quinoxaline, quinazoline, cinnoline, phthalazine, naphthyridine, purine, pteridine, benzopyrazole, and benzopiperidine; and fused tricyclic heterocycles such as carbazole, acridine, and phenazine.
Examples of a heterocycle containing only oxygen atom(s) as the heteroatom include monocyclic saturated heterocycles such as oxirane, oxetane, tetrahydrofuran, tetrahydropyran, 1,3-dioxane, and 1,4-dioxane; bicyclic saturated heterocycles such as 1,4-dioxaspiro[4.5]decane and 1,4-dioxaspiro[4.5]nonane; lactone heterocycles such as α-

acetolactone, $\beta$-propiolactone, $\gamma$-butyrolactone, and $\delta$-valerolactone; 5-membered unsaturated heterocycles such as furan; 6-membered unsaturated heterocycles such as 2H-pyran and 4H-pyran; fused bicyclic heterocycles such as 1-benzofuran, benzopyran, benzodioxole, chroman, and isochroman; and fused tricyclic heterocycles such as xanthene and dibenzofuran.

Examples of a heterocycle containing only sulfur atom(s) as the heteroatom include 5-membered saturated heterocycles such as dithiolane; 6-membered saturated heterocycles such as thiane and 1,3-dithiane; 5-membered unsaturated heterocycles such as thiophene; 6-membered unsaturated heterocycles such as 4H-thiopyran; fused bicyclic heterocycles such as benzothiopyran including benzotetrahydrothiopyran and the like, and benzothiophene; and fused tricyclic heterocycles such as thianthrene and dibenzothiophene.

Examples of a heterocycle containing nitrogen atom(s) and oxygen atom(s) as heteroatoms include monocyclic saturated heterocycles such as morpholine, 2-pyrrolidone, and 2-piperidone; monocyclic unsaturated heterocycles such as oxazole and isoxazole; fused bicyclic heterocycles such as benzoxazole, benzoisoxazole, benzoxazine, benzodioxane, and benzimidazoline; and fused tricyclic heterocycles such as phenoxazine.

Examples of a heterocycle containing nitrogen atom(s) and sulfur atom(s) as heteroatoms include monocyclic heterocycles such as thiazole; fused bicyclic heterocycles such as benzothiazole; and fused tricyclic heterocycles such as phenothiazine.

The heterocyclic group preferably has 2 to 30 carbon atoms, more preferably 3 to 22 carbon atoms, and still more preferably 3 to 20 carbon atoms.

The heterocyclic group optionally has a substituent. Examples of the substituent include a halogen atom, a nitro group, a cyano group, $-OR^{a1}$, $-CO_2R^{a1}$, $-SR^{a1}$, $-SO_2R^{a1}$, $-SO_3R^{a1}$, $-SO_2NR^{a1}R^{a2}$, and $-NR^{a1}R^{a2}$, wherein $R^{a1}$ and $R^{a2}$ are the same as mentioned above.

The bonding position of the heterocycle is at a portion where any hydrogen atom contained in each ring is eliminated.

Examples of the halogen atom used as the substituent of the C1-C20 hydrocarbon group represented by $R^1$ to $R^5$ include a fluorine atom, a chlorine atom, a bromine atom, and an iodine atom.

When $R^2$ is a single bond connecting $Z^3$ and $R^1$, $R^1$ is a hydrocarbon group having 1 to 20 carbon atoms and optionally having a substituent, and a part or the whole of $R^1$ forms a ring together with $*-Z^3-P(=Z^1)-Z^2-*$ (* represents a bond). That is, when $R^2$ is a single bond connecting $Z^3$ and $R^1$, a bond formed by sharing a pair of electrons between $Z^3$ and any carbon atom in the C1-C20 hydrocarbon group optionally having a substituent represented by $R^1$ corresponds to a single bond represented by $R^2$.

Examples of the halogen atom represented by $X^1$ to $X^{12}$ include a fluorine atom, a chlorine atom, a bromine atom, and an iodine atom. Among these, a fluorine atom is preferable.

The sulfamoyl group represented by $X^1$ to $X^{12}$ is represented by $*-SO_2-NH_2$ (* means a point of attachment).

The sulfamoyl group represented by $X^1$ to $X^{12}$ optionally has a substituent. Examples of the substituent of the sulfamoyl group represented by $X^1$ to $X^{12}$ include an aromatic hydrocarbon group having 6 to 20 carbon atoms and optionally having a substituent, a heterocyclic group optionally having a substituent, a halogen atom, a nitro group, a cyano group, $-OR^{a1}$, $-CO_2R^{a1}$, $-SR^{a1}$, $-SO_2R^{a1}$, $-SO_3R^{a1}$, $-SO_2NR^{a1}R^{a2}$, and $-NR^{a1}R^{a2}$ (provided that $R^{a1}$ and $R^{a2}$ are the same as mentioned above). Examples of the heterocyclic group optionally having a substituent and the halogen atom used as a substituent of the sulfamoyl group represented by $X^1$ to $X^{12}$ include the same as those exemplified for the heterocyclic group optionally having a substituent and the halogen atom used as a substituent of the C1-C20 hydrocarbon group represented by $R^1$ to $R^5$, and their preferred embodiments are also the same.

Examples of the C6-C20 aromatic hydrocarbon group used as the substituent of the sulfamoyl group represented by $X^1$ to $X^{12}$ include phenyl, o-tolyl, m-tolyl, p-tolyl, 2-ethylphenyl, 3-ethylphenyl, 4-ethylphenyl, 2,3-dimethylphenyl, 2,4-dimethylphenyl, 2,5-dimethylphenyl, 2,6-dimethylphenyl, 3,4-dimethylphenyl, 3,5-dimethylphenyl, 4-vinylphenyl, o-isopropylphenyl, m-isopropylphenyl, p-isopropylphenyl, o-tert-butylphenyl, m-tert-butylphenyl, p-tert-butylphenyl, 3,5-di(tert-butyl)phenyl, 3,5-di(tert-butyl)-4-methylphenyl, 4-butylphenyl, 4-pentylphenyl, 2,6-bis(1-methylethyl)phenyl, 2,4,6-tris(1-methylethyl)phenyl, 4-cyclohexylphenyl, 2,4,6-trimethylphenyl, 4-octylphenyl, 4-(1,1,3,3-tetramethylbutyl)phenyl, 1-naphthyl, 2-naphthyl, 6-methyl-2-naphthyl, 5,6,7,8-tetrahydro-1-naphthyl, 5,6,7,8-tetrahydro-2-naphthyl, fluorenyl, phenanthryl, anthryl, 2-dodecylphenyl, 3-dodecylphenyl, 4-dodecylphenyl, perylenyl, chrysenyl, and pyrenyl.

The aromatic hydrocarbon group preferably has 6 to 10 carbon atoms, more preferably 6 to 8 carbon atoms.

The aromatic hydrocarbon group optionally has a substituent. Examples of the substituent include a halogen atom, a nitro group, a cyano group, $-OR^{a1}$, $-CO_2R^{a1}$, $-SR^{a1}$, $-SO_2R^{a1}$, $-SO_3R^{a1}$, $-SO_2NR^{a1}R^{a2}$, and $-NR^{a1}R^{a2}$, wherein $R^{a1}$ and $R^{a2}$ are the same as mentioned above.

$-R^4$ represented by $X^1$ to $X^4$ and $-R^5$ represented by $X^5$ to $X^{12}$ are preferably an aliphatic hydrocarbon group having 1 to 20 carbon atoms, more preferably a saturated chain hydrocarbon group having 1 to 20 carbon atoms, still more preferably a saturated chain hydrocarbon group having 1 to 10 carbon atoms, further preferably a branched-chain alkyl group having 1 to 5 carbon atoms, and particularly preferably a tert-butyl group.

In formula (I), $R^1$ is

preferably an aromatic hydrocarbon group having 6 to 20 carbon atoms and optionally having a substituent;
more preferably an aromatic hydrocarbon group having 6 to 10 carbon atoms and optionally having a substituent;
still more preferably an aromatic hydrocarbon group having 6 to 8 carbon atoms and optionally having a substituent; and
particularly preferably a phenyl group optionally having a substituent.

$R^2$ is

preferably an unsaturated hydrocarbon group having 2 to 20 carbon atoms and optionally having a substituent, or an aromatic hydrocarbon group having 6 to 20 carbon atoms and optionally having a substituent;
more preferably an unsaturated chain hydrocarbon group having 2 to 10 carbon atoms and optionally having a substituent, or an aromatic hydrocarbon group having 6 to 10 carbon atoms and optionally having a substituent;
still more preferably an unsaturated chain hydrocarbon group having 2 to 7 carbon atoms and optionally having a substituent, or an aromatic hydrocarbon group having 6 to 8 carbon atoms and optionally having a substituent;
further preferably an alkenyl group having 2 to 7 carbon atoms and optionally having a substituent, or an aromatic hydrocarbon group having 6 to 8 carbon atoms and optionally having a substituent; and
particularly preferably an ethenyl group optionally having a substituent, or a phenyl group optionally having a substituent.

n1 to n4 are each independently preferably 0 to 2, more preferably 0 to 1, and still more preferably 0.

$X^1$ to $X^4$ are each independently preferably $-R^4$ or a halogen atom.

At least one of $Y^1$, $Z^1$, $Z^2$ and $Z^3$ represents a sulfur atom, and it is preferable to satisfy at least one of an embodiment in which $Y^1$ is a sulfur atom and $Z^1$ is an oxygen atom, an embodiment in which $Y^1$ is an oxygen atom and $Z^1$ is a sulfur atom, and an embodiment in which $Z^2$ and $Z^3$ are a sulfur atom. However, when $R^2$ is an unsaturated hydrocarbon group, $Z^2$ and $Z^3$ are preferably a single bond.

When $Y^1$ is a sulfur atom and $Z^1$ is an oxygen atom, and when $Y^1$ is an oxygen atom and $Z^1$ is a sulfur atom, it is preferable that $Z^2$ be a single bond, an oxygen atom or a sulfur atom, $Z^3$ be a single bond, an oxygen atom or a sulfur atom, $R^1$ be an aromatic hydrocarbon group having 6 to 20 carbon atoms and optionally having a substituent, and $R^2$ be an aromatic hydrocarbon group having 6 to 20 carbon atoms and optionally having a substituent; or $Z^2$ be a single bond, $Z^3$ be a single bond, $R^1$ be an aromatic hydrocarbon group having 6 to 20 carbon atoms and optionally having a substituent, and $R^2$ be an unsaturated hydrocarbon group having 2 to 20 carbon atoms and optionally having a substituent, and it is more preferable that $Z^2$ be a single bond, $Z^3$ be a single bond, $R^1$ be an aromatic hydrocarbon group having 6 to 8 carbon atoms and optionally having a substituent, and $R^2$ be an aromatic hydrocarbon group having 6 to 8 carbon atoms and optionally having a substituent; or $Z^2$ be a single bond, $Z^3$ be a single bond, $R^1$ be an aromatic hydrocarbon group having 6 to 8 carbon atoms and optionally having a substituent, and $R^2$ be an unsaturated hydrocarbon group having 2 to 7 carbon atoms and optionally having a substituent.

When $Z^2$ and $Z^3$ are a sulfur atom, it is preferable that $Y^1$ be an oxygen atom or a sulfur atom, $Z^1$ be an oxygen atom or a sulfur atom, $R^1$ be an aromatic hydrocarbon group having 6 to 20 carbon atoms and optionally having a substituent, and $R^2$ be an aromatic hydrocarbon group having 6 to 20 carbon atoms and optionally having a substituent, and it is more preferable that $Y^1$ be an oxygen atom, $Z^1$ be an oxygen atom, $R^1$ be an aromatic hydrocarbon group having 6 to 8 carbon atoms and optionally having a substituent, and $R^2$ be an aromatic hydrocarbon group having 6 to 8 carbon atoms and optionally having a substituent.

In formula (II), $R^3$ is

preferably an unsaturated hydrocarbon group having 2 to 20 carbon atoms and optionally having a substituent, or an aromatic hydrocarbon group having 6 to 20 carbon atoms and optionally having a substituent;
more preferably an unsaturated chain hydrocarbon group having 2 to 10 carbon atoms and optionally having a substituent, or an aromatic hydrocarbon group having 6 to 10 carbon atoms and optionally having a substituent;
still more preferably an unsaturated chain hydrocarbon group having 2 to 7 carbon atoms and optionally having a substituent, or an aromatic hydrocarbon group having 6 to 8 carbon atoms and optionally having a substituent;
further preferably an alkenyl group having 2 to 7 carbon atoms and optionally having a substituent, or an aromatic hydrocarbon group having 6 to 8 carbon atoms and optionally having a substituent; and
particularly preferably an ethenyl group optionally having a substituent, or a phenyl group optionally having a substituent.

n5 to n12 are each independently preferably 0 to 2, more preferably 0 to 1, and still more preferably 0.

$X^5$ to $X^{12}$ are each independently preferably $-R^5$ or a halogen atom.

At least one of $Y^2$, $Z^4$, and $Z^5$ represents a sulfur atom. However, when $R^3$ is an unsaturated hydrocarbon group, $Z^5$ is preferably a single bond.

When $Y^2$ is a sulfur atom and $Z^4$ is an oxygen atom, and when $Y^2$ is an oxygen atom and $Z^4$ is a sulfur atom,

it is preferable that $Z^5$ be a single bond or an oxygen atom, and $R^3$ be an aromatic hydrocarbon group having 6 to 20 carbon atoms and optionally having a substituent; or $Z^5$ be a single bond, and $R^3$ be an unsaturated hydrocarbon group having 2 to 20 carbon atoms and optionally having a substituent, and it is more preferable that $Z^5$ be a single bond, and $R^3$ be an aromatic hydrocarbon group having 6 to 8 carbon atoms and optionally having a substituent; or $Z^5$ be a single bond, and $R^3$ be an unsaturated hydrocarbon group having 2 to 7 carbon atoms and optionally having a substituent.

When $Y^2$ is an oxygen atom and $Z^4$ is a sulfur atom, and when $Y^2$ and $Z^4$ are a sulfur atom, it is preferable that $Z^5$ be a single bond or an oxygen atom, and $R^3$ be an aromatic hydrocarbon group having 6 to 20 carbon atoms and optionally having a substituent; or $Z^5$ be a single bond, and $R^3$ be an unsaturated hydrocarbon group having 2 to 20 carbon atoms and optionally having a substituent, it is more preferable that $Z^5$ be a single bond, and $R^3$ be an aromatic hydrocarbon group having 6 to 8 carbon atoms and optionally having a substituent; or $Z^5$ be a single bond, and $R^3$ be an unsaturated hydrocarbon group having 2 to 7 carbon atoms and optionally having a substituent, and it is still more preferable that $Z^5$ be a single bond, and $R^3$ be an unsaturated hydrocarbon group having 2 to 7 carbon atoms and optionally having a substituent.

Examples of compounds represented by formula (I) include compounds represented by formulas (IA) to (IE).

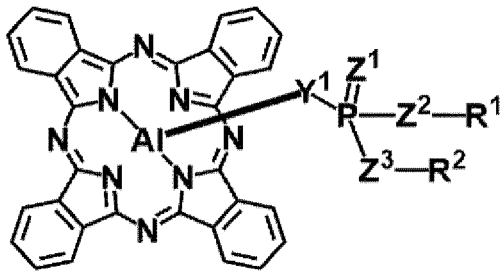

(IA)

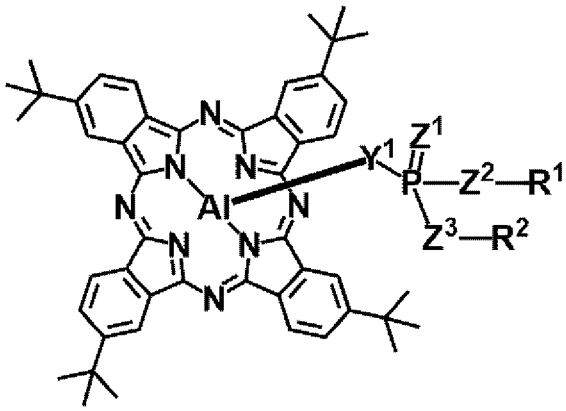

(IB)

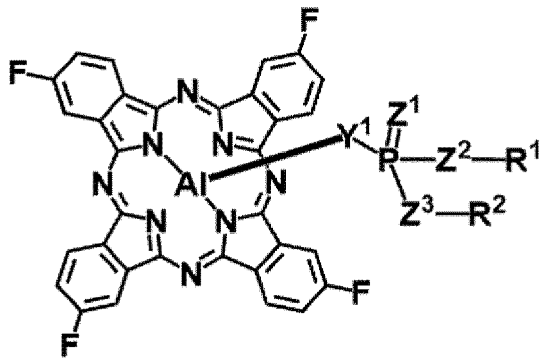

(IC)

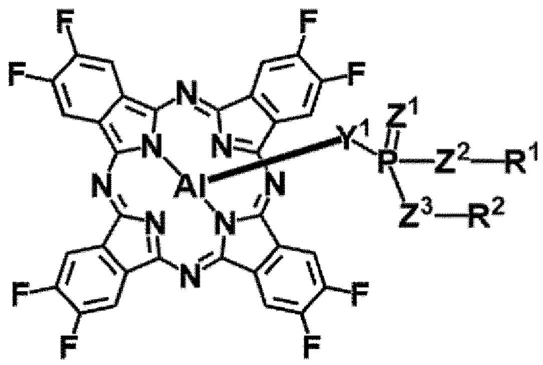

(ID)

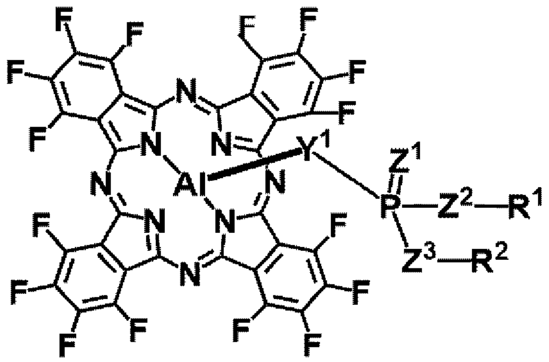

(IE)

In formulas (IA) to (IE), $R^1$, $R^2$, $Y^1$, $Z^1$, $Z^2$, and $Z^3$ are the same as mentioned above.

Examples of compounds represented by formula (IA) include compounds represented by formulas (IA-1) to (IA-24) shown in Table 1.

Examples of compounds represented by formula (IB) include compounds represented by formulas (IB-1) to (IB-24) shown in Table 2.

Examples of compounds represented by formula (IC) include compounds represented by formulas (IC-1) to (IC-24) shown in Table 3.

Examples of compounds represented by formula (ID) include compounds represented by formulas (ID-1) to (ID-24) shown in Table 4.

Examples of compounds represented by formula (IE) include compounds represented by formulas (IE-1) to (IE-24) shown in Table 5.

In Tables 1 to 5, "i-1" represents a phenyl group, and "i-2" represents an ethenyl group.

[Table 1]

| | $Y^1$ | $Z^1$ | $Z^2$ | $Z^2$ | $R^1$ | $R^2$ |
|---|---|---|---|---|---|---|
| (IA-1) | sulfur atom | oxygen atom | single bond | single bond | i-1 | i-1 |
| (IA-2) | sulfur atom | oxygen atom | single bond | oxygen atom | i-1 | i-1 |
| (IA-3) | sulfur atom | oxygen atom | single bond | sulfur atom | i-1 | i-1 |
| (IA-4) | sulfur atom | oxygen atom | oxygen atom | oxygen atom | i-1 | i-1 |
| (IA-5) | sulfur atom | oxygen atom | oxygen atom | sulfur atom | i-1 | i-1 |
| (IA-6) | sulfur atom | oxygen atom | sulfur atom | sulfur atom | i-1 | i-1 |
| (IA-7) | sulfur atom | sulfur atom | single bond | single bond | i-1 | i-1 |
| (IA-8) | sulfur atom | sulfur atom | single bond | oxygen atom | i-1 | i-1 |
| (IA-9) | sulfur atom | sulfur atom | single bond | sulfur atom | i-1 | i-1 |
| (IA-10) | sulfur atom | sulfur atom | oxygen atom | oxygen atom | i-1 | i-1 |
| (IA-11) | sulfur atom | sulfur atom | oxygen atom | sulfur atom | i-1 | i-1 |

(continued)

| | $Y^1$ | $Z^1$ | $Z^2$ | $Z^2$ | $R^1$ | $R^2$ |
|---|---|---|---|---|---|---|
| (IA-12) | sulfur atom | sulfur atom | sulfur atom | sulfur atom | i-1 | i-1 |
| (IA-13) | oxygen atom | sulfur atom | single bond | single bond | i-1 | i-1 |
| (IA-14) | oxygen atom | sulfur atom | single bond | oxygen atom | i-1 | i-1 |
| (IA-15) | oxygen atom | sulfur atom | single bond | sulfur atom | i-1 | i-1 |
| (IA-16) | oxygen atom | sulfur atom | oxygen atom | oxygen atom | i-1 | i-1 |
| (IA-17) | oxygen atom | sulfur atom | oxygen atom | sulfur atom | i-1 | i-1 |
| (IA-18) | oxygen atom | sulfur atom | sulfur atom | sulfur atom | i-1 | i-1 |
| (IA-19) | oxygen atom | oxygen atom | single bond | sulfur atom | i-1 | i-1 |
| (IA-20) | oxygen atom | oxygen atom | oxygen atom | sulfur atom | i-1 | i-1 |
| (IA-21) | oxygen atom | oxygen atom | sulfur atom | sulfur atom | i-1 | i-1 |
| (IA-22) | sulfur atom | oxygen atom | single bond | single bond | i-1 | i-2 |
| (IA-23) | sulfur atom | sulfur atom | single bond | single bond | i-1 | i-2 |
| (IA-24) | oxygen atom | sulfur atom | single bond | single bond | i-1 | i-2 |

As the compound represented by formula (IA),

compounds represented by formulas (IA-1) to (IA-6), (IA-13) to (IA-18), (IA-21), and (IA-22) to (IA-24) are preferable; compounds represented by formulas (IA-1) to (IA-13), (IA-21), (IA-23), and (IA-24) are more preferable.

[Table 2]

| | $Y^1$ | $Z^1$ | $Z^2$ | $Z^2$ | $R^1$ | $R^2$ |
|---|---|---|---|---|---|---|
| (IB-1) | sulfur atom | oxygen atom | single bond | single bond | i-1 | i-1 |
| (IB-2) | sulfur atom | oxygen atom | single bond | oxygen atom | i-1 | i-1 |
| (IB-3) | sulfur atom | oxygen atom | single bond | sulfur atom | i-1 | i-1 |
| (IB-4) | sulfur atom | oxygen atom | oxygen atom | oxygen atom | i-1 | i-1 |
| (IB-5) | sulfur atom | oxygen atom | oxygen atom | sulfur atom | i-1 | i-1 |
| (IB-6) | sulfur atom | oxygen atom | sulfur atom | sulfur atom | i-1 | i-1 |
| (IB-7) | sulfur atom | sulfur atom | single bond | single bond | i-1 | i-1 |
| (IB-8) | sulfur atom | sulfur atom | single bond | oxygen atom | i-1 | i-1 |
| (IB-9) | sulfur atom | sulfur atom | single bond | sulfur atom | i-1 | i-1 |
| (IB-10) | sulfur atom | sulfur atom | oxygen atom | oxygen atom | i-1 | i-1 |
| (IB-11) | sulfur atom | sulfur atom | oxygen atom | sulfur atom | i-1 | i-1 |
| (IB-12) | sulfur atom | sulfur atom | sulfur atom | sulfur atom | i-1 | i-1 |
| (IB-13) | oxygen atom | sulfur atom | single bond | single bond | i-1 | i-1 |
| (IB-14) | oxygen atom | sulfur atom | single bond | oxygen atom | i-1 | i-1 |
| (IB-15) | oxygen atom | sulfur atom | single bond | sulfur atom | i-1 | i-1 |
| (IB-16) | oxygen atom | sulfur atom | oxygen atom | oxygen atom | i-1 | i-1 |
| (IB-17) | oxygen atom | sulfur atom | oxygen atom | sulfur atom | i-1 | i-1 |
| (IB-18) | oxygen atom | sulfur atom | sulfur atom | sulfur atom | i-1 | i-1 |

(continued)

| | $Y^1$ | $Z^1$ | $Z^2$ | $Z^2$ | $R^1$ | $R^2$ |
|---|---|---|---|---|---|---|
| (IB-19) | oxygen atom | oxygen atom | single bond | sulfur atom | i-1 | i-1 |
| (IB-20) | oxygen atom | oxygen atom | oxygen atom | sulfur atom | i-1 | i-1 |
| (IB-21) | oxygen atom | oxygen atom | sulfur atom | sulfur atom | i-1 | i-1 |
| (IB-22) | sulfur atom | oxygen atom | single bond | single bond | i-1 | i-2 |
| (IB-23) | sulfur atom | sulfur atom | single bond | single bond | i-1 | i-2 |
| (IB-24) | oxygen atom | sulfur atom | single bond | single bond | i-1 | i-2 |

As the compound represented by formula (IB),

compounds represented by formulas (IB-1) to (IB-6), (IB-13) to (IB-18), (IB-21), and (IB-22) to (IB-24) are preferable; compounds represented by formulas (IB-1) to (IB-13), (IB-21), (IB-23), and (IB-24) are more preferable.

[Table 3]

| | $Y^1$ | $Z^1$ | $Z^2$ | $Z^2$ | $R^1$ | $R^2$ |
|---|---|---|---|---|---|---|
| (IC-1) | sulfur atom | oxygen atom | single bond | single bond | i-1 | i-1 |
| (IC-2) | sulfur atom | oxygen atom | single bond | oxygen atom | i-1 | i-1 |
| (IC-3) | sulfur atom | oxygen atom | single bond | sulfur atom | i-1 | i-1 |
| (IC-4) | sulfur atom | oxygen atom | oxygen atom | oxygen atom | i-1 | i-1 |
| (IC-5) | sulfur atom | oxygen atom | oxygen atom | sulfur atom | i-1 | i-1 |
| (IC-6) | sulfur atom | oxygen atom | sulfur atom | sulfur atom | i-1 | i-1 |
| (IC-7) | sulfur atom | sulfur atom | single bond | single bond | i-1 | i-1 |
| (IC-8) | sulfur atom | sulfur atom | single bond | oxygen atom | i-1 | i-1 |
| (IC-9) | sulfur atom | sulfur atom | single bond | sulfur atom | i-1 | i-1 |
| (IC-10) | sulfur atom | sulfur atom | oxygen atom | oxygen atom | i-1 | i-1 |
| (IC-11) | sulfur atom | sulfur atom | oxygen atom | sulfur atom | i-1 | i-1 |
| (IC-12) | sulfur atom | sulfur atom | sulfur atom | sulfur atom | i-1 | i-1 |
| (IC-13) | oxygen atom | sulfur atom | single bond | single bond | i-1 | i-1 |
| (IC-14) | oxygen atom | sulfur atom | single bond | oxygen atom | i-1 | i-1 |
| (IC-15) | oxygen atom | sulfur atom | single bond | sulfur atom | i-1 | i-1 |
| (IC-16) | oxygen atom | sulfur atom | oxygen atom | oxygen atom | i-1 | i-1 |
| (IC-17) | oxygen atom | sulfur atom | oxygen atom | sulfur atom | i-1 | i-1 |
| (IC-18) | oxygen atom | sulfur atom | sulfur atom | sulfur atom | i-1 | i-1 |
| (IC-19) | oxygen atom | oxygen atom | single bond | sulfur atom | i-1 | i-1 |
| (IC-20) | oxygen atom | oxygen atom | oxygen atom | sulfur atom | i-1 | i-1 |
| (IC-21) | oxygen atom | oxygen atom | sulfur atom | sulfur atom | i-1 | i-1 |
| (IC-22) | sulfur atom | oxygen atom | single bond | single bond | i-1 | i-2 |
| (IC-23) | sulfur atom | sulfur atom | single bond | single bond | i-1 | i-2 |
| (IC-24) | oxygen atom | sulfur atom | single bond | single bond | i-1 | i-2 |

As the compound represented by formula (IC),

compounds represented by formulas (IC-1) to (IC-6), (IC-13) to (IC-18), (IC-21), and (IC-22) to (IC-24) are preferable; compounds represented by formulas (IC-1) to (IC-13), (IC-21), (IC-23), and (IC-24) are more preferable.

[Table 4]

| | $Y^1$ | $Z^1$ | $Z^2$ | $Z^2$ | $R^1$ | $R^2$ |
|---|---|---|---|---|---|---|
| (ID-1) | sulfur atom | oxygen atom | single bond | single bond | i-1 | i-1 |
| (ID-2) | sulfur atom | oxygen atom | single bond | oxygen atom | i-1 | i-1 |
| (ID-3) | sulfur atom | oxygen atom | single bond | sulfur atom | i-1 | i-1 |
| (ID-4) | sulfur atom | oxygen atom | oxygen atom | oxygen atom | i-1 | i-1 |
| (ID-5) | sulfur atom | oxygen atom | oxygen atom | sulfur atom | i-1 | i-1 |
| (ID-6) | sulfur atom | oxygen atom | sulfur atom | sulfur atom | i-1 | i-1 |
| (ID-7) | sulfur atom | sulfur atom | single bond | single bond | i-1 | i-1 |
| (ID-8) | sulfur atom | sulfur atom | single bond | oxygen atom | i-1 | i-1 |
| (ID-9) | sulfur atom | sulfur atom | single bond | sulfur atom | i-1 | i-1 |
| (ID-10) | sulfur atom | sulfur atom | oxygen atom | oxygen atom | i-1 | i-1 |
| (ID-11) | sulfur atom | sulfur atom | oxygen atom | sulfur atom | i-1 | i-1 |
| (ID-12) | sulfur atom | sulfur atom | sulfur atom | sulfur atom | i-1 | i-1 |
| (ID-13) | oxygen atom | sulfur atom | single bond | single bond | i-1 | i-1 |
| (ID-14) | oxygen atom | sulfur atom | single bond | oxygen atom | i-1 | i-1 |
| (ID-15) | oxygen atom | sulfur atom | single bond | sulfur atom | i-1 | i-1 |
| (ID-16) | oxygen atom | sulfur atom | oxygen atom | oxygen atom | i-1 | i-1 |
| (ID-17) | oxygen atom | sulfur atom | oxygen atom | sulfur atom | i-1 | i-1 |
| (ID-18) | oxygen atom | sulfur atom | sulfur atom | sulfur atom | i-1 | i-1 |
| (ID-19) | oxygen atom | oxygen atom | single bond | sulfur atom | i-1 | i-1 |
| (ID-20) | oxygen atom | oxygen atom | oxygen atom | sulfur atom | i-1 | i-1 |
| (ID-21) | oxygen atom | oxygen atom | sulfur atom | sulfur atom | i-1 | i-1 |
| (ID-22) | sulfur atom | oxygen atom | single bond | single bond | i-1 | i-2 |
| (ID-23) | sulfur atom | sulfur atom | single bond | single bond | i-1 | i-2 |
| (ID-24) | oxygen atom | sulfur atom | single bond | single bond | i-1 | i-2 |

As the compound represented by formula (ID),

compounds represented by formulas (ID-1) to (ID-6), (ID-13) to (ID-18), (ID-21), and (ID-22) to (ID-24) are preferable; compounds represented by formulas (ID-1) to (ID-13), (ID-21), (ID-23), and (ID-24) are more preferable.

[Table 5]

| | $Y^1$ | $Z^1$ | $Z^2$ | $Z^2$ | $R^1$ | $R^2$ |
|---|---|---|---|---|---|---|
| (IE-1) | sulfur atom | oxygen atom | single bond | single bond | i-1 | i-1 |
| (IE-2) | sulfur atom | oxygen atom | single bond | oxygen atom | i-1 | i-1 |
| (IE-3) | sulfur atom | oxygen atom | single bond | sulfur atom | i-1 | i-1 |

(continued)

| | $Y^1$ | $Z^1$ | $Z^2$ | $Z^2$ | $R^1$ | $R^2$ |
|---|---|---|---|---|---|---|
| (IE-4) | sulfur atom | oxygen atom | oxygen atom | oxygen atom | i-1 | i-1 |
| (IE-5) | sulfur atom | oxygen atom | oxygen atom | sulfur atom | i-1 | i-1 |
| (IE-6) | sulfur atom | oxygen atom | sulfur atom | sulfur atom | i-1 | i-1 |
| (IE-7) | sulfur atom | sulfur atom | single bond | single bond | i-1 | i-1 |
| (IE-8) | sulfur atom | sulfur atom | single bond | oxygen atom | i-1 | i-1 |
| (IE-9) | sulfur atom | sulfur atom | single bond | sulfur atom | i-1 | i-1 |
| (IE-10) | sulfur atom | sulfur atom | oxygen atom | oxygen atom | i-1 | i-1 |
| (IE-11) | sulfur atom | sulfur atom | oxygen atom | sulfur atom | i-1 | i-1 |
| (IE-12) | sulfur atom | sulfur atom | sulfur atom | sulfur atom | i-1 | i-1 |
| (IE-13) | oxygen atom | sulfur atom | single bond | single bond | i-1 | i-1 |
| (IE-14) | oxygen atom | sulfur atom | single bond | oxygen atom | i-1 | i-1 |
| (IE-15) | oxygen atom | sulfur atom | single bond | sulfur atom | i-1 | i-1 |
| (IE-16) | oxygen atom | sulfur atom | oxygen atom | oxygen atom | i-1 | i-1 |
| (IE-17) | oxygen atom | sulfur atom | oxygen atom | sulfur atom | i-1 | i-1 |
| (IE-18) | oxygen atom | sulfur atom | sulfur atom | sulfur atom | i-1 | i-1 |
| (IE-19) | oxygen atom | oxygen atom | single bond | sulfur atom | i-1 | i-1 |
| (IE-20) | oxygen atom | oxygen atom | oxygen atom | sulfur atom | i-1 | i-1 |
| (IE-21) | oxygen atom | oxygen atom | sulfur atom | sulfur atom | i-1 | i-1 |
| (IE-22) | sulfur atom | oxygen atom | single bond | single bond | i-1 | i-2 |
| (IE-23) | sulfur atom | sulfur atom | single bond | single bond | i-1 | i-2 |
| (IE-24) | oxygen atom | sulfur atom | single bond | single bond | i-1 | i-2 |

As the compound represented by formula (IE),

compounds represented by formulas (IE-1) to (IE-6), (IE-13) to (IE-18), (IE-21), and (IE-22) to (IE-24) are preferable; compounds represented by formulas (IE-1) to (IE-13), (IE-21), (IE-23), and (IE-24) are more preferable.

Examples of compounds represented by formula (II) include compounds represented by formulas (IIA) to (IIE).

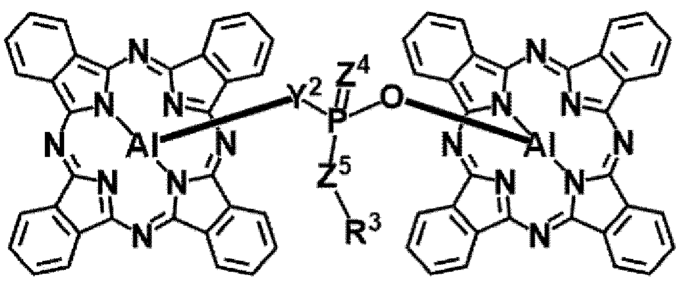

(IIA)

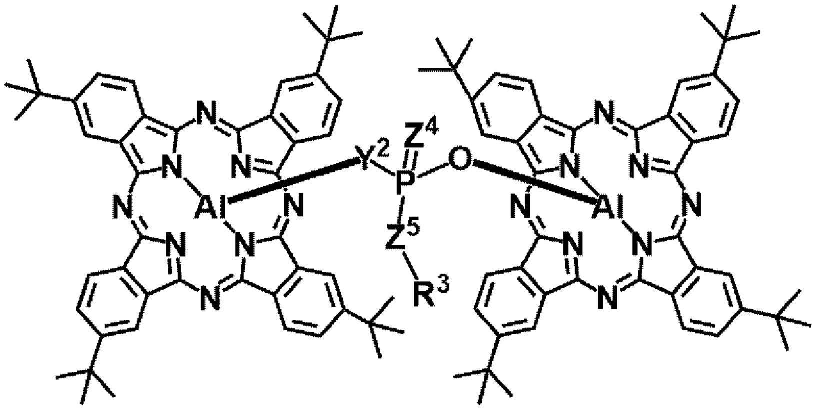

(IIB)

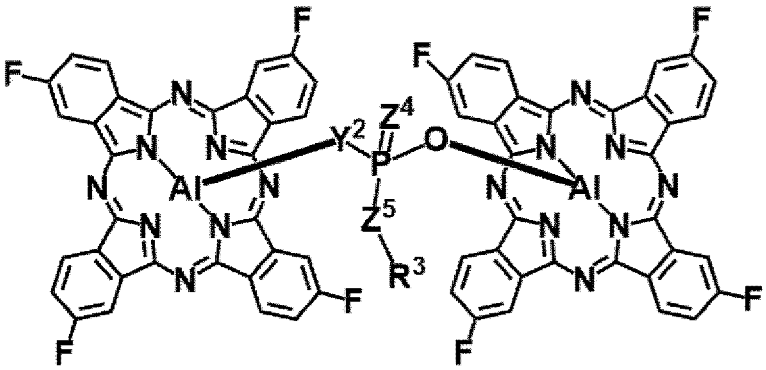

(IIC)

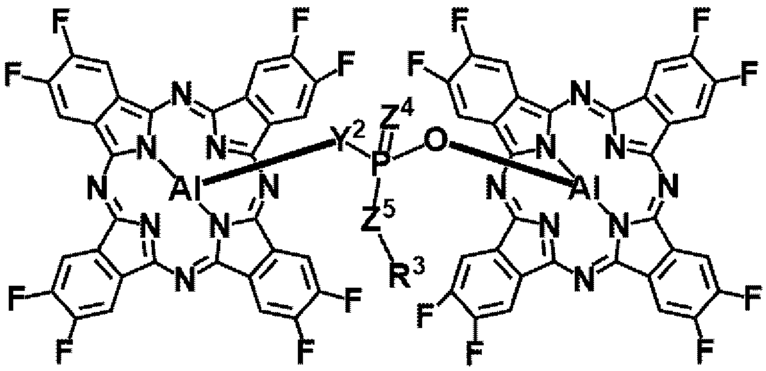

(IID)

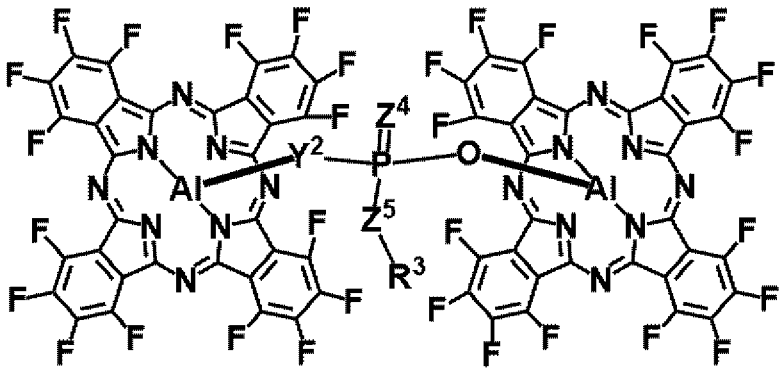

(IIE)

In formulas (IIA) to (IIE), $R^3$, $Y^2$, $Z^4$, and $Z^5$ are the same as mentioned above.

Examples of compounds represented by formula (IIA) include compounds represented by formulas (IIA-1) to (IIA-13) shown in Table 6.

Examples of compounds represented by formula (IIB) include compounds represented by formulas (IIB-1) to

(IIB-13) shown in Table 7.

Examples of compounds represented by formula (IIC) include compounds represented by formulas (IIC-1) to (IIC-13) shown in Table 8.

Examples of compounds represented by formula (IID) include compounds represented by formulas (IID-1) to (IID-13) shown in Table 9.

Examples of compounds represented by formula (IIE) include compounds represented by formulas (IIE-1) to (IIE-13) shown in Table 10.

In Tables 6 to 10, "i-1" represents a phenyl group, and "i-2" represents an ethenyl group.

[Table 6]

| | $Y^2$ | $Z^4$ | $Z^5$ | $R^3$ |
|---|---|---|---|---|
| (IIA-1) | sulfur atom | oxygen atom | single bond | i-1 |
| (IIA-2) | sulfur atom | oxygen atom | oxygen atom | i-1 |
| (IIA-3) | sulfur atom | oxygen atom | sulfur atom | i-1 |
| (IIA-4) | sulfur atom | sulfur atom | single bond | i-1 |
| (IIA-5) | sulfur atom | sulfur atom | oxygen atom | i-1 |
| (IIA-6) | sulfur atom | sulfur atom | sulfur atom | i-1 |
| (IIA-7) | oxygen atom | oxygen atom | sulfur atom | i-1 |
| (IIA-8) | oxygen atom | sulfur atom | single bond | i-1 |
| (IIA-9) | oxygen atom | sulfur atom | oxygen atom | i-1 |
| (IIA-10) | oxygen atom | sulfur atom | sulfur atom | i-1 |
| (IIA-11) | sulfur atom | oxygen atom | single bond | i-2 |
| (IIA-12) | sulfur atom | sulfur atom | single bond | i-2 |
| (IIA-13) | oxygen atom | sulfur atom | single bond | i-2 |

As the compound represented by formula (IIA),

compounds represented by formulas (IIA-1), (IIA-2), (IIA-8), (IIA-9), (IIA-12), and (IIA-13) are preferable;
compounds represented by formulas (IIA-1), (IIA-8), (IIA-12), and (IIA-13) are more preferable.

[Table 7]

| | $Y^2$ | $Z^4$ | $Z^5$ | $R^3$ |
|---|---|---|---|---|
| (IIB-1) | sulfur atom | oxygen atom | single bond | i-1 |
| (IIB-2) | sulfur atom | oxygen atom | oxygen atom | i-1 |
| (IIB-3) | sulfur atom | oxygen atom | sulfur atom | i-1 |
| (IIB-4) | sulfur atom | sulfur atom | single bond | i-1 |
| (IIB-5) | sulfur atom | sulfur atom | oxygen atom | i-1 |
| (IIB-6) | sulfur atom | sulfur atom | sulfur atom | i-1 |
| (IIB-7) | oxygen atom | oxygen atom | sulfur atom | i-1 |
| (IIB-8) | oxygen atom | sulfur atom | single bond | i-1 |
| (IIB-9) | oxygen atom | sulfur atom | oxygen atom | i-1 |
| (IIB-10) | oxygen atom | sulfur atom | sulfur atom | i-1 |
| (IIB-11) | sulfur atom | oxygen atom | single bond | i-2 |
| (IIB-12) | sulfur atom | sulfur atom | single bond | i-2 |

(continued)

| | $Y^2$ | $Z^4$ | $Z^5$ | $R^3$ |
|---|---|---|---|---|
| (IIB-13) | oxygen atom | sulfur atom | single bond | i-2 |

As the compound represented by formula (IIB),

compounds represented by formulas (IIB-1), (IIB-2), (IIB-8), (IIB-9), (IIB-12), and (IIB-13) are preferable; compounds represented by formulas (IIB-1), (IIB-8), (IIB-12), and (IIB-13) are more preferable.

[Table 8]

| | $Y^2$ | $Z^4$ | $Z^5$ | $R^3$ |
|---|---|---|---|---|
| (IIC-1) | sulfur atom | oxygen atom | single bond | i-1 |
| (IIC-2) | sulfur atom | oxygen atom | oxygen atom | i-1 |
| (IIC-3) | sulfur atom | oxygen atom | sulfur atom | i-1 |
| (IIC-4) | sulfur atom | sulfur atom | single bond | i-1 |
| (IIC-5) | sulfur atom | sulfur atom | oxygen atom | i-1 |
| (IIC-6) | sulfur atom | sulfur atom | sulfur atom | i-1 |
| (IIC-7) | oxygen atom | oxygen atom | sulfur atom | i-1 |
| (IIC-8) | oxygen atom | sulfur atom | single bond | i-1 |
| (IIC-9) | oxygen atom | sulfur atom | oxygen atom | i-1 |
| (IIC-10) | oxygen atom | sulfur atom | sulfur atom | i-1 |
| (IIC-11) | sulfur atom | oxygen atom | single bond | i-2 |
| (IIC-12) | sulfur atom | sulfur atom | single bond | i-2 |
| (IIC-13) | oxygen atom | sulfur atom | single bond | i-2 |

As the compound represented by formula (IIC),

compounds represented by formulas (IIC-1), (IIC-2), (IIC-8), (IIC-9), (IIC-12), and (IIC-13) are preferable; compounds represented by formulas (IIC-1), (IIC-8), (IIC-12), and (IIC-13) are more preferable.

[Table 9]

| | $Y^2$ | $Z^4$ | $Z^5$ | $R^3$ |
|---|---|---|---|---|
| (IID-1) | sulfur atom | oxygen atom | single bond | i-1 |
| (IID-2) | sulfur atom | oxygen atom | oxygen atom | i-1 |
| (IID-3) | sulfur atom | oxygen atom | sulfur atom | i-1 |
| (IID-4) | sulfur atom | sulfur atom | single bond | i-1 |
| (IID-5) | sulfur atom | sulfur atom | oxygen atom | i-1 |
| (IID-6) | sulfur atom | sulfur atom | sulfur atom | i-1 |
| (IID-7) | oxygen atom | oxygen atom | sulfur atom | i-1 |
| (IID-8) | oxygen atom | sulfur atom | single bond | i-1 |
| (IID-9) | oxygen atom | sulfur atom | oxygen atom | i-1 |
| (IID-10) | oxygen atom | sulfur atom | sulfur atom | i-1 |

(continued)

| | $Y^2$ | $Z^4$ | $Z^5$ | $R^3$ |
|---|---|---|---|---|
| (IID-11) | sulfur atom | oxygen atom | single bond | i-2 |
| (IID-12) | sulfur atom | sulfur atom | single bond | i-2 |
| (IID-13) | oxygen atom | sulfur atom | single bond | i-2 |

As the compound represented by formula (IID),

compounds represented by formulas (IID-1), (IID-2), (IID-8), (IID-9), (IID-12), and (IID-13) are preferable; compounds represented by formulas (IID-1), (IID-8), (IID-12), and (IID-13) are more preferable.

[Table 10]

| | $Y^2$ | $Z^4$ | $Z^5$ | $R^3$ |
|---|---|---|---|---|
| (IIE-1) | sulfur atom | oxygen atom | single bond | i-1 |
| (IIE-2) | sulfur atom | oxygen atom | oxygen atom | i-1 |
| (IIE-3) | sulfur atom | oxygen atom | sulfur atom | i-1 |
| (IIE-4) | sulfur atom | sulfur atom | single bond | i-1 |
| (IIE-5) | sulfur atom | sulfur atom | oxygen atom | i-1 |
| (IIE-6) | sulfur atom | sulfur atom | sulfur atom | i-1 |
| (IIE-7) | oxygen atom | oxygen atom | sulfur atom | i-1 |
| (IIE-8) | oxygen atom | sulfur atom | single bond | i-1 |
| (IIE-9) | oxygen atom | sulfur atom | oxygen atom | i-1 |
| (IIE-10) | oxygen atom | sulfur atom | sulfur atom | i-1 |
| (IIE-11) | sulfur atom | oxygen atom | single bond | i-2 |
| (IIE-12) | sulfur atom | sulfur atom | single bond | i-2 |
| (IIE-13) | oxygen atom | sulfur atom | single bond | i-2 |

As the compound represented by formula (IIE),

compounds represented by formulas (IIE-1), (IIE-2), (IIE-8), (IIE-9), (IIE-12), and (IIE-13) are preferable; compounds represented by formulas (IIE-1), (IIE-8), (IIE-12), and (IIE-13) are more preferable.

The compound represented by formula (I) can be produced, for example, by appropriately reacting the compound represented by formula (III) with the compound represented by formula (IV).

The compound represented by formula (II) can be produced, for example, by appropriately reacting the compounds represented by formulas (IIIa) and (IIIb) with the compound represented by formula (V).

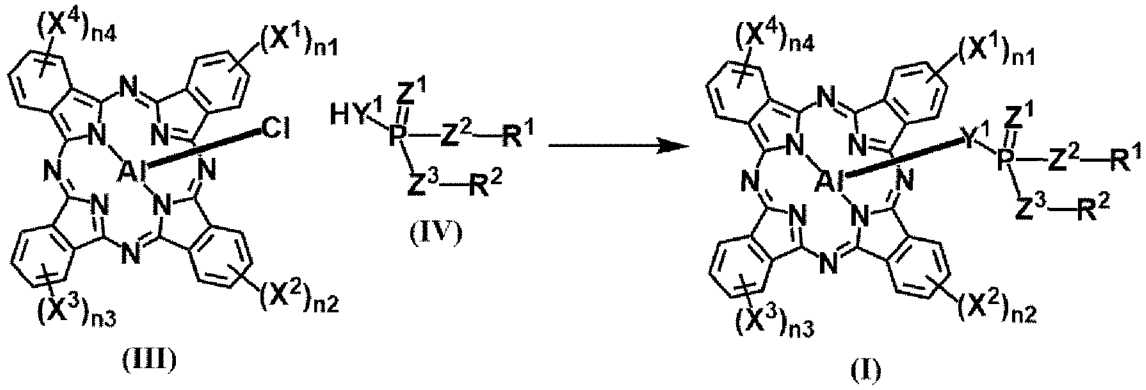

(III) (IV) (I)

In formulas (I), (III), and (IV), $R^1$, $R^2$, $Y^1$, $Z^1$, $Z^2$, $Z^3$, $X^1$ to $X^4$, and n1 to n4 are the same as mentioned above.

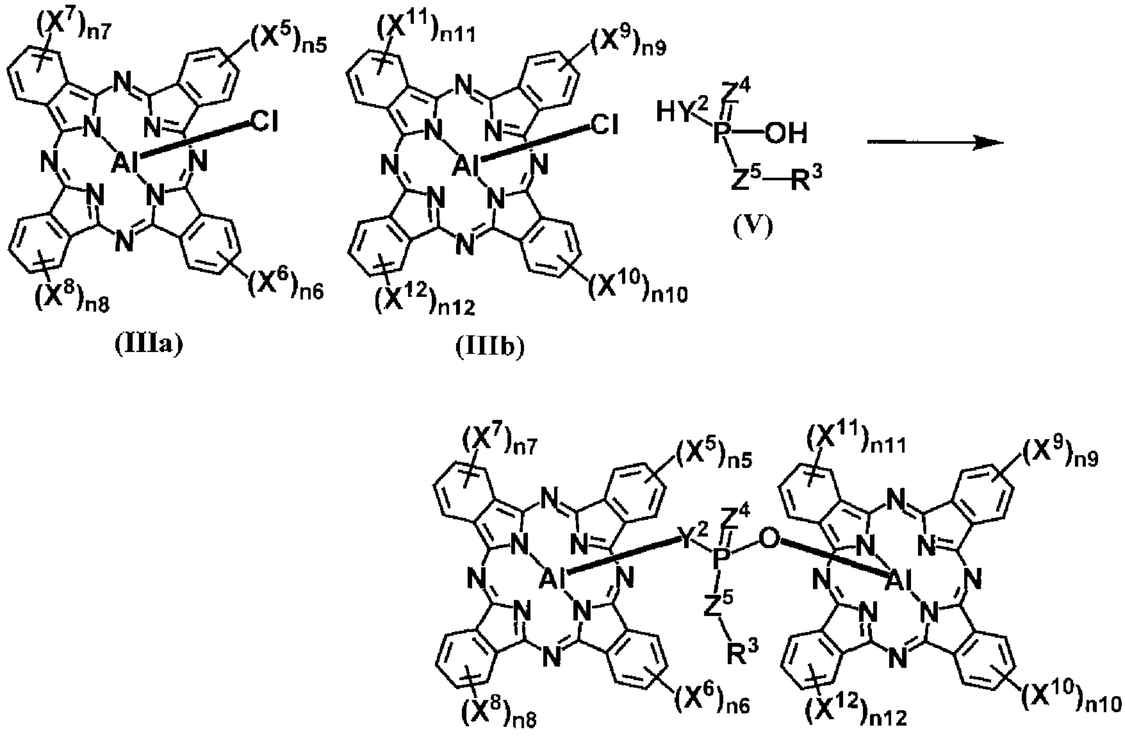

(IIIa) (IIIb) (V)

(II)

In formulas (II), (IIIa), (IIIb), and (V), $R^3$, $Y^2$, $Z^4$, $Z^5$, $X^5$ to $X^{12}$, and n5 to n12 are the same as mentioned above.

«Colored Resin Composition»

The present invention includes a colored resin composition containing the compound represented by formula (I) or formula (II) described above and a resin (hereinafter, sometimes referred to as a resin (B)).

The present invention also includes a colored resin composition further containing a polymerizable compound (hereinafter, sometimes referred to as a polymerizable compound (C)) and a polymerization initiator (hereinafter, sometimes referred to as a polymerization initiator (D)).

The colored resin composition of the present invention preferably contains the compounds represented by formula (I) and/or formula (II) (hereinafter, sometimes referred to as a colorant (A1)) as a colorant (hereinafter, sometimes referred to as a colorant (A)).

The colored resin composition of the present invention preferably further contains a solvent (hereinafter, sometimes referred to as a solvent (E)).

The colored resin composition of the present invention may contain a leveling agent (hereinafter, sometimes

referred to as a leveling agent (F)).

Herein, compounds exemplified as each component may be used singly or in combination of a plurality thereof unless otherwise noted.

<Colorant (A)>

The content of the colorant (A1) is preferably 0.5 to 70% by mass, more preferably 1 to 55% by mass, still more preferably 2 to 50% by mass, and particularly preferably 5 to 40% by mass in the whole amount of the solid content of the colored resin composition.

Herein, the term "whole amount of the solid content" means the total amount of components obtained by excluding the solvent from the colored resin composition of the present invention. The whole amount of the solid content and the content of each of the components with respect thereto can be measured by known analysis means such as liquid chromatography or gas chromatography.

The content of the colorant (A1) in the whole amount of the colorant (A) is preferably 20 to 100% by mass, more preferably 30 to 100% by mass, and still more preferably 40 to 100% by mass.

The colorant (A) may further contain a different colorant (hereinafter, sometimes referred to as a colorant (A2)) from the colorant (A1).

The colorant (A2) may be one or both of a dye and a pigment.

Examples of the dye include a compound that is not a pigment but classified into a compound having a hue in the Color Index (published by The Society of Dyers and Colourists), and a known dye as described in Dying note (Shikisensha Co., Ltd.). Particularly preferred is a xanthene dye.

The xanthene dye is a dye containing a compound having a xanthene skeleton in its molecule. Specific examples of the xanthene dye include C.I. Acid Red 51 (hereinafter, the term "C.I. Acid Red" is omitted and only the number is shown; ditto for other dyes), 52, 87, 92, 94, 289, and 388; C.I. Acid Violet 9, 30, and 102; C.I. Basic Red 1 (Rhodamine 6G), 2, 3, 4, 8, 10, and 11; C.I. Basic Violet 10 (Rhodamine B) and 11; C.I. Solvent Red 218; C.I. Mordant Red 27; C.I. Reactive Red 36 (Rose Bengal B); Sulforhodamine G; a xanthene dye described in Japanese Patent Laid-Open No. 2010-32999; and a xanthene dye described in Japanese Patent No. 4492760. The xanthene dye is preferably dissolved in an organic solvent.

The xanthene dye may be any commercially available xanthene dye such as "Chugai Aminol Fast Pink R-H/C" manufactured by Chugai Kasei Co., Ltd., or "Rhodamin 6G" manufactured by Taoka Chemical Co., Ltd.. The xanthene dye may also be one synthesized with a commercially available xanthene dye as a starting material, with reference to Japanese Patent Laid-Open No. 2010-32999.

As other dyes, an azo dye, a cyanine dye, a triphenylmethane dye, a thiazole dye, an oxazine dye, a phthalocyanine dye, a quinophthalone dye, an anthraquinone dye, a naphthoquinone dye, a quinonimine dye, a methine dye, an azomethine dye, a squarylium dye, an acridine dye, a styryl dye, a coumarin dye, a quinoline dye, a nitro dye, and the like may be used, and for each of these dyes, known dyes are used.

Specific examples of the dye include

C. I. Solvent dyes such as:

C. I. Solvent Yellow 4 (hereinafter, the term "C. I. Solvent Yellow" is omitted and only the number is shown; ditto for other dyes), 14, 15, 23, 24, 38, 62, 63, 68, 82, 94, 98, 99, 117, 162, 163, 167, and 189;
C. I. Solvent Red 45, 49, 111, 125, 130, 143, 145, 146, 150, 151, 155, 168, 169, 172, 175, 181, 207, 222, 227, 230, 245, and 247;
C. I. Solvent Orange 2, 7, 11, 15, 26, 56, 77, and 86;
C. I. Solvent Violet 11, 13, 14, 26, 31, 36, 37, 38, 45, 47, 48, 51, 59, and 60;
C. I. Solvent Blue 4, 5, 14, 18, 35, 36, 37, 45, 58, 59, 59:1, 63, 67, 68, 69, 70, 78, 79, 83, 90, 94, 97, 98, 100, 101, 102, 104, 105, 111, 112, 122, 128, 132, 136, and 139; and
C. I. Solvent Green 1, 3, 4, 5, 7, 28, 29, 32, 33, 34, and 35,

C. I. Acid dyes such as:

C. I. Acid Yellow 1, 3, 7, 9, 11, 17, 23, 25, 29, 34, 36, 38, 40, 42, 54, 65, 72, 73, 76, 79, 98, 99, 111, 112, 113, 114, 116, 119, 123, 128, 134, 135, 138, 139, 140, 144, 150, 155, 157, 160, 161, 163, 168, 169, 172, 177, 178, 179, 184, 190, 193, 196, 197, 199, 202, 203, 204, 205, 207, 212, 214, 220, 221, 228, 230, 232, 235, 238, 240, 242, 243, and 251;
C. I. Acid Red 1, 4, 8, 14, 17, 18, 26, 27, 29, 31, 33, 34, 35, 37, 40, 42, 44, 50, 57, 66, 73, 76, 80, 88, 91, 95, 97, 98, 103, 106, 111, 114, 129, 133, 134, 138, 143, 145, 150, 151, 155, 158, 160, 172, 176, 182, 183, 195,

198, 206, 211, 215, 216, 217, 227, 228, 249, 252, 257, 258, 260, 261, 266, 268, 270, 274, 277, 280, 281, 308, 312, 315, 316, 339, 341, 345, 346, 349, 382, 383, 394, 401, 412, 417, 418, 422, and 426;
C. I. Acid Orange 6, 7, 8, 10, 12, 26, 50, 51, 52, 56, 62, 63, 64, 74, 75, 94, 95, 107, 108, 169, and 173;
C. I. Acid Violet 6B, 7, 15, 16, 17, 19, 21, 23, 24, 25, 34, 38, 49, and 72;
C.I. Acid Blue 1, 3, 5, 7, 9, 11, 13, 15, 17, 18, 22, 23, 24, 25, 26, 27, 29, 34, 38, 40, 41, 42, 43, 45, 48, 51, 54, 59, 60, 62, 70, 72, 74, 75, 78, 80, 82, 83, 86, 87, 88, 90, 90:1, 91, 92, 93, 93:1, 96, 99, 100, 102, 103, 104, 108, 109, 110, 112, 113, 117, 119, 120, 123, 126, 127, 129, 130, 131, 138, 140, 142, 143, 147, 150, 151, 154, 158, 161, 166, 167, 168, 170, 171, 175, 182, 183, 184, 187, 192, 199, 203, 204, 205, 210, 213, 229, 234, 236, 242, 243, 256, 259, 267, 269, 278, 280, 285, 290, 296, 315, 324:1, 335, and 340; and
C. I. Acid Green 1, 3, 5, 6, 7, 8, 9, 11, 13, 14, 15, 16, 22, 25, 27, 28, 41, 50, 50:1, 58, 63, 65, 80, 104, 105, 106, and 109,

C. I. Direct dyes such as:

C. I. Direct Yellow 2, 33, 34, 35, 38, 39, 43, 47, 50, 54, 58, 68, 69, 70, 71, 86, 93, 94, 95, 98, 102, 108, 109, 129, 136, 138, and 141;
C. I. Direct Red 79, 82, 83, 84, 91, 92, 96, 97, 98, 99, 105, 106, 107, 172, 173, 176, 177, 179, 181, 182, 184, 204, 207, 211, 213, 218, 220, 221, 222, 232, 233, 234, 241, 243, 246, and 250;
C. I. Direct Orange 26, 34, 39, 41, 46, 50, 52, 56, 57, 61, 64, 65, 68, 70, 96, 97, 106, and 107;
C. I. Direct Violet 47, 52, 54, 59, 60, 65, 66, 79, 80, 81, 82, 84, 89, 90, 93, 95, 96, 103, and 104;
C. I. Direct Blue 1, 2, 3, 6, 8, 15, 22, 25, 28, 29, 40, 41, 42, 47, 52, 55, 57, 71, 76, 77, 78, 80, 81, 84, 85, 86, 90, 93, 94, 95, 97, 98, 99, 100, 101, 106, 107, 108, 109, 113, 114, 115, 117, 119, 120, 137, 149, 150, 153, 155, 156, 158, 159, 160, 161, 162, 163, 164, 165, 166, 167, 168, 170, 171, 172, 173, 188, 189, 190, 192, 193, 194, 195, 196, 198, 199, 200, 201, 202, 203, 207, 209, 210, 212, 213, 214, 222, 225, 226, 228, 229, 236, 237, 238, 242, 243, 244, 245, 246, 247, 248, 249, 250, 251, 252, 256, 257, 259, 260, 268, 274, 275, and 293; and C. I. Direct Greens 25, 27, 31, 32, 34, 37, 63, 65, 66, 67, 68, 69, 72, 77, 79, and 82,

C. I. Disperse dyes such as:

C. I. Disperse Yellow 51, 54, and 76;
C. I. Disperse Violet 26 and 27; and
C. I. Disperse Blue 1, 14, 56, and 60,

C. I. Basic dyes such as:

C. I. Basic Blue 1, 3, 5, 7, 9, 19, 21, 22, 24, 25, 26, 28, 29, 40, 41, 45, 47, 54, 58, 59, 60, 64, 65, 66, 67, 68, 81, 83, 88, and 89;
C. I. Basic Violet 2;
C. I. Basic Red 9; and
C. I. Basic Green 1,

C. I. Reactive dyes such as:

C. I. Reactive Yellow 2, 76, and 116;
C. I. Reactive Orange 16; and
C. I. Reactive Red 36,

C. I. Mordant dyes such as:

C. I. Mordant Yellow 5, 8, 10, 16, 20, 26, 30, 31, 33, 42, 43, 45, 56, 61, 62, and 65;
C. I. Mordant Red 1, 2, 3, 4, 9, 11, 12, 14, 17, 18, 19, 22, 23, 24, 25, 26, 29, 30, 32, 33, 36, 37, 38, 39, 41, 42, 43, 45, 46, 48, 52, 53, 56, 62, 63, 71, 74, 76, 78, 85, 86, 88, 90, 94, and 95;
C. I. Mordant Orange 3, 4, 5, 8, 12, 13, 14, 20, 21, 23, 24, 28, 29, 32, 34, 35, 36, 37, 42, 43, 47, and 48;
C. I. Mordant Violet 1, 1:1, 2, 3, 4, 5, 6, 7, 8, 10, 11, 14, 15, 16, 17, 18, 19, 21, 22, 23, 24, 27, 28, 30, 31, 32, 33, 36, 37, 39, 40, 41, 44, 45, 47, 48, 49, 53, and 58;
C. I. Mordant Blue 1, 2, 3, 7, 8, 9, 12, 13, 15, 16, 19, 20, 21, 22, 23, 24, 26, 30, 31, 32, 39, 40, 41, 43, 44, 48, 49, 53, 61, 74, 77, 83, and 84; and
C. I. Mordant Green 1, 3, 4, 5, 10, 13, 15, 19, 21, 23, 26, 29, 31, 33, 34, 35, 41, 43, and 53; and

C. I. Vat dyes such as:

C. I. Vat Green 1.

One dye or a plurality of dyes may be used for each of the colors of these dyes, and the dyes of the colors may be used in combination.
Examples of the pigment include a pigment that is classified into a pigment in the Color Index (published by The Society of Dyers and Colourists).
Specific examples of the pigment include

green pigments such as C.I. Pigment Green 7, 36, and 58;
yellow pigments such as C.I. Pigment Yellow 1, 3, 12, 13, 14, 15, 16, 17, 20, 24, 31, 53, 83, 86, 93, 94, 109, 110, 117, 125, 128, 129, 137, 138, 139, 147, 148, 150, 153, 154, 166, 173, 185, 194, and 214;
orange pigments such as C.I. Pigment Orange 13, 31, 36, 38, 40, 42, 43, 51, 55, 59, 61, 64, 65, 71, and 73;
red pigments such as C.I. Pigment Red 9, 97, 105, 122, 123, 144, 149, 166, 168, 176, 177, 180, 192, 209, 215, 216, 224, 242, 254, 255, 264, and 265;
blue pigments such as C.I. Pigment Blue 15, 15:3, 15:4, 15:6, and 60; and
violet pigments such as C.I. Pigment Violet 1, 19, 23, 29, 32, 36, and 38.

One pigment or a plurality of pigments may be used for each of the colors of these pigments, and the pigments of the colors may be used in combination.
If necessary, the pigment may be subjected to a treatment such as a rosin treatment; a surface treatment using a pigment derivative or the like having an introduced acidic group or basic group; a pigment surface graft treatment with a polymeric compound or the like; a particle micronization treatment by a sulfuric acid micronization method or the like; a washing treatment with an organic solvent, water or the like for removing impurities; or a removing treatment of ionic impurities by an ionic exchange method or the like. The pigment preferably has a substantially uniform particle diameter. To the pigment, a pigment dispersant is added, followed by performing a dispersion treatment, whereby a pigment dispersion in which the pigment is uniformly dispersed may be produced. The pigment may be each independently subjected to the dispersion treatment, or a plurality of pigments may be together subjected to the dispersion treatment.
Examples of the pigment dispersant include surfactants such as a cationic surfactant, an anionic surfactant, a non-ionic surfactant, and an amphoteric surfactant. Specific examples thereof include surfactants such as a polyester-based surfactant, a polyamine-based surfactant, and an acrylic surfactant. These pigment dispersants may be used singly or in combination of two or more thereof. Examples in trade names of the pigment dispersant include KP (manufactured by Shin-Etsu Chemical Co., Ltd.), Flowlen (manufactured by Kyoeisha Chemical Co., Ltd.), Solsperse (registered trademark) (manufactured by Zeneca Ltd.), EFKA (registered trademark) (manufactured by BASF Corporation), AJISPER (registered trademark) (manufactured by Ajinomoto Fine-Techno Co., Inc.), Disperbyk (registered trademark) (manufactured by BYK-Chemie Corporation), and BYK (registered trademark) (manufactured by BYK-Chemie Corporation).
When the pigment dispersant is used, the amount thereof used is preferably 10 parts by mass or more and 200 parts by mass or less, more preferably 15 parts by mass or more and 180 parts by mass or less, and still more preferably 20 parts by mass or more and 160 parts by mass or less, relative to 100 parts by mass of the pigment. When the amount of the pigment dispersant used falls within the above-mentioned range, a pigment dispersion in which two or more pigments are more uniformly dispersed tends to be obtained.
When the colorant (A) contains the colorant (A2), the content of the colorant (A2) is preferably 1 to 80% by mass, more preferably 1 to 70% by mass, and still more preferably 1 to 60% by mass, in the whole amount of the colorant (A).
The content of the colorant (A) is preferably 0.5 to 80% by mass, more preferably 1 to 70% by mass, and still more preferably 2 to 55% by mass, in the whole amount of the solid content. When the content of the compound falls within the above-mentioned range, desired spectroscopy and color density are more likely to be obtained.

<Resin (B)>

The resin (B) is not particularly limited, and is preferably an alkali soluble resin. Examples of the resin (B) include the following resins [K1] to [K6].

Resin [K1]; a copolymer having a structural unit derived from at least one monomer (a) selected from the group consisting of an unsaturated carboxylic acid and an unsaturated carboxylic anhydride (hereinafter, the monomer (a) is sometimes referred to as "(a)") and a structural unit derived from a monomer (b) having a cyclic ether structure

having 2 to 4 carbon atoms and an ethylenically unsaturated bond (hereinafter, monomer (b) is sometimes referred to as "(b)");

Resin [K2]; a copolymer having a structural unit derived from (a), a structural unit derived from (b), and a structural unit derived from a monomer (c) copolymerizable with (a) (hereinafter, the monomer (c) is sometimes referred to as "(c)");

Resin [K3]; a copolymer having a structural unit derived from (a) and a structural unit derived from (c);

Resin [K4]; a copolymer having (i) a structural unit produced by adding (b) to a structural unit derived from (a) and (ii) a structural unit derived from (c);

Resin [K5]; a copolymer having (i) a structural unit produced by adding (a) to a structural unit derived from (b) and (ii) a structural unit derived from (c); and

Resin [K6]; a copolymer having (i) a structural unit produced by adding (a) to a structural unit derived from (b) and further adding a carboxylic anhydride thereto, and (ii) a structural unit derived from (c).

It is noted that (c) is different from (a) and (b).

Specific examples of (a) include unsaturated monocarboxylic acids such as acrylic acid, methacrylic acid, crotonic acid, and o-, m- or p-vinylbenzoic acid;

unsaturated dicarboxylic acids such as maleic acid, fumaric acid, citraconic acid, mesaconic acid, itaconic acid, 3-vinylphthalic acid, 4-vinylphthalic acid, 3,4,5,6-tetrahydrophthalic acid, 1,2,3,6-tetrahydrophthalic acid, dimethyltetrahydrophthalic acid, and 1,4-cyclohexenedicarboxylic acid;

carboxy group-containing bicyclo unsaturated compounds such as methyl-5-norbornene-2,3-dicarboxylic acid, 5-carboxybicyclo[2.2.1]hept-2-ene, 5,6-dicarboxybicyclo[2.2.1]hept-2-ene, 5-carboxy-5-methylbicyclo[2.2.1]hept-2-ene, 5-carboxy-5-ethylbicyclo[2.2.1]hept-2-ene, 5-carboxy-6-methylbicyclo[2.2.1]hept-2-ene, and 5-carboxy-6-ethylbicyclo[2.2.1]hept-2-ene;

unsaturated dicarboxylic anhydrides such as maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride;

unsaturated mono[(meth)acryloyloxyalkyl]esters of a polyvalent carboxylic acid having a valence of 2 or more such as succinic acid mono[2-(meth)acryloyloxyethyl], and phthalic acid mono [2-(meth) acryloyloxy ethyl]; and

unsaturated acrylates containing a hydroxy group and a carboxy group in its molecule such as α-(hydroxymethyl)acrylic acid.

Among these, from the viewpoint of copolymerization reactivity and solubility of obtained resin to an alkaline aqueous solution, acrylic acid, methacrylic acid, maleic anhydride and the like are preferable.

(b) means a polymerizable compound having a cyclic ether structure having 2 to 4 carbon atoms (for example, at least one selected from the group consisting of an oxirane ring, an oxetane ring, and a tetrahydrofuran ring) and an ethylenically unsaturated bond. (b) is preferably a monomer having a cyclic ether having 2 to 4 carbon atoms and a (meth)acryloyloxy group.

As used herein, "(meth)acrylic acid" represents at least one selected from the group consisting of acrylic acid and methacrylic acid. The terms "(meth)acryloyl", "(meth)acrylate" and the like also have similar meanings.

Examples of (b) include a monomer (b1) having an oxiranyl group and an ethylenically unsaturated bond (hereinafter, the monomer (b1) is sometimes referred to as "(b1)"), a monomer (b2) having an oxetanyl group and an ethylenically unsaturated bond (hereinafter, the monomer (b2) is sometimes referred to as "(b2)"), and a monomer (b3) having a tetrahydrofuryl group and an ethylenically unsaturated bond (hereinafter, the monomer (b3) is sometimes referred to as "(b3)").

Examples of (b1) include a monomer (b1-1) having a structure where a straight- or branched-chain aliphatic unsaturated hydrocarbon is epoxidized (hereinafter, the monomer (b1-1) is sometimes referred to as "(b1-1)") and a monomer (b1-2) having a structure where an alicyclic unsaturated hydrocarbon is epoxidized (hereinafter, sometimes referred to as "(b1-2)").

Examples of (b1-1) include glycidyl(meth)acrylate, β-methylglycidyl(meth)acrylate, β-ethylglycidyl(meth)acrylate, glycidyl vinyl ether, o-vinylbenzyl glycidyl ether, m-vinylbenzyl glycidyl ether, p-vinylbenzyl glycidyl ether, α-methyl-o-vinylbenzyl glycidyl ether, α-methyl-m-vinylbenzyl glycidyl ether, α-methyl-p-vinylbenzyl glycidyl ether, 2,3-bis(glycidyloxymethyl)styrene, 2,4-bis(glycidyloxymethyl)styrene, 2,5-bis(glycidyloxymethyl)styrene, 2,6-bis(glycidyloxymethyl)styrene, 2,3,4-tris(glycidyloxymethyl)styrene, 2,3,5-tris(glycidyloxymethyl)styrene, 2,3,6-tris(glycidyloxymethyl)styrene, 3,4,5-tris(glycidyloxymethyl)styrene, and 2,4,6-tris(glycidyloxymethyl) styrene.

Examples of (b1-2) include vinylcyclohexene monoxide, 1,2-epoxy-4-vinylcyclohexane (for example, Celloxide 2000 manufactured by Daicel Corporation), 3,4-epoxycyclohexylmethyl(meth)acrylate (for example, Cyclomer A400 manufactured by Daicel Corporation), 3,4-epoxycyclohexylmethyl(meth)acrylate (for example, Cyclomer M100 manufactured by Daicel Corporation), 3,4-epoxytricyclo[5.2.1.0$^{2,6}$]decyl(meth)acrylate, and 3,4-epoxytricyclo [5.2.1.0$^{2,6}$] decyloxyethyl(meth)acrylate.

(b2) is more preferably a monomer having an oxetanyl group and a (meth)acryloyloxy group. Examples of (b2) include 3-methyl-3-methacryloyloxy methyl oxetane, 3-methyl-3-acryloyloxy methyl oxetane, 3-ethyl-3-methacryloyloxy methyl oxetane, 3-ethyl-3-acryloyloxy methyl oxetane, 3-methyl-3-methacryloyloxy ethyl oxetane, 3-methyl-3-acryloyloxy ethyl oxetane, 3-ethyl-3-methacryloyloxy ethyl oxetane, and 3-ethyl-3-acryloyloxy ethyl oxetane.

(b3) is more preferably a monomer having a tetrahydrofuryl group and a (meth)acryloyloxy group. Specific examples of (b3) include tetrahydrofurfuryl acrylate (for example, Viscoat V#150 manufactured by Osaka Organic Chemical Industry Ltd.) and tetrahydrofurfuryl methacrylate.

(b) is preferably (b1) since reliabilities such as heat resistance and chemical resistance of an optical filter to be produced can be further improved, and more preferably (b1-2) since the storage stability of the colored resin composition is excellent.

Examples of (c) include

(meth)acrylic esters such as methyl(meth)acrylate, ethyl(meth)acrylate, n-butyl(meth)acrylate, sec-butyl(meth)acrylate, tert-butyl(meth)acrylate, 2-ethylhexyl(meth)acrylate, dodecyl(meth)acrylate, lauryl(meth)acrylate, stearyl(meth)acrylate, cyclopentyl(meth)acrylate, cyclohexyl(meth)acrylate, 2-methylcyclohexyl(meth)acrylate, tricyclo[5.2.1.0$^{2,6}$]decan-8-yl(meth)acrylate (which is referred to as "dicyclopentanyl(meth)acrylate" (common name) in the art or sometimes referred to as "tricyclodecyl(meth)acrylate"), tricyclo [5.2.1.0$^{2,6}$]decene-8-yl (meth)acrylate (which is referred to as "dicyclopentenyl(meth)acrylate" (common name) in the art), dicyclopentanyloxyethyl(meth)acrylate, isobornyl(meth)acrylate, adamantyl(meth)acrylate, allyl(meth)acrylate, propargyl(meth)acrylate, phenyl(meth)acrylate, naphthyl(meth)acrylate, and benzyl(meth)acrylate;

hydroxy group-containing (meth)acrylic esters such as 2-hydroxyethyl(meth)acrylate and 2-hydroxypropyl(meth)acrylate;

dicarboxylic diesters such as diethyl maleate, diethyl fumarate, and diethyl itaconate;

bicyclo unsaturated compounds such as bicyclo[2.2.1]hept-2-ene, 5-methylbicyclo[2.2.1]hept-2-ene, 5-ethylbicyclo[2.2.1]hept-2-ene, 5-hydroxybicyclo[2.2.1]hept-2-ene, 5-hydroxymethylbicyclo[2.2.1]hept-2-ene, 5-(2'-hydroxyethyl)bicyclo[2.2.1]hept-2-ene, 5-methoxybicyclo[2.2.1]hept-2-ene, 5-ethoxybicyclo[2.2.1]hept-2-ene, 5,6-dihydroxybicyclo[2.2.1]hept-2-ene, 5,6-di(hydroxymethyl)bicyclo[2.2.1]hept-2-ene, 5,6-di(2'-hydroxyethyl)bicyclo[2.2.1]hept-2-ene, 5,6-dimethoxybicyclo[2.2.1]hept-2-ene, 5,6-diethoxybicyclo[2.2.1]hept-2-ene, 5-hydroxy-5-methylbicyclo[2.2.1]hept-2-ene, 5-hydroxy-5-ethylbicyclo[2.2.1]hept-2-ene, 5-hydroxymethyl-5-methylbicyclo [2.2.1]hept-2-ene, 5-tert-butoxycarbonylbicyclo[2.2.1]hept-2-ene, 5-cyclohexyloxycarbonylbicyclo[2.2.1]hept-2-ene, 5-phenoxycarbonylbicyclo[2.2.1]hept-2-ene, 5,6-bis(tert-butoxycarbonyl)bicyclo[2.2.1]hept-2-ene, and 5,6-bis(cyclohexyloxycarbonyl)bicyclo[2.2.1]hept-2-ene;

dicarbonylimide derivatives such as N-phenylmaleimide, N-cyclohexylmaleimide, N-benzylmaleimide, N-succinimidyl-3-maleimidobenzoate, N-succinimidyl-4-maleimidobutyrate, N-succinimidyl-6-maleimide caproate, N-succinimidyl-3-maleimide propionate, and N-(9-acridinyl)maleimide;

styrene, $\alpha$-methylstyrene, m-methylstyrene, p-methylstyrene, vinyltoluene, p-methoxystyrene, acrylonitrile, methacrylonitrile, vinyl chloride, vinylidene chloride, acrylamide, methacrylamide, vinyl acetate, 1,3-butadiene, isoprene, and 2,3-dimethyl-1,3-butadiene.

Among these, from the viewpoint of copolymerization reactivity and heat resistance, styrene, vinyltoluene, N-phenylmaleimide, N-cyclohexylmaleimide, N-benzylmaleimide, bicyclo[2.2.1]hept-2-ene, and the like are preferable.

The ratio of the structural unit derived from each of (a) and (b) in the total structural units constituting the resin [K1] is preferably the following:

the structural unit derived from (a): 2 to 60 mol%; and
the structural unit derived from (b): 40 to 98 mol%,

and more preferably the following:

the structural unit derived from (a): 10 to 50 mol%; and
the structural unit derived from (b): 50 to 90 mol%.

When the ratio of the structural unit of the resin [K1] falls within the above-mentioned range, there is a tendency that the storage stability of the colored resin composition, the developability thereof during the formation of a colored pattern, and the solvent resistance of an optical filter to be produced are excellent.

The resin [K1] can be produced with reference to the method described in, for example, a document "Experimental Method for Polymer Synthesis" (edited by Takayuki Otsu, published by Kagaku-Dojin Publishing Co., Ltd., First Edition, First Printed on Mar. 1, 1972) and cited documents described in the document.

Specific examples the producing method of the resin [K1] include the following method: predetermined amounts of (a) and (b), a polymerization initiator, a solvent, and the like are placed in a reaction vessel, a deoxidization atmosphere is formed by, for example, substituting oxygen with nitrogen, and these are heated and kept warm during stirring. The polymerization initiator, the solvent, and the like used here are not particularly limited, and those commonly used in the art can be used. Examples of the polymerization initiator include azo compounds such as 2,2'-azobisisobutyronitrile and 2,2'-azobis(2,4-dimethylvaleronitrile, and organic peroxides such as benzoyl peroxide. The solvent is required to dissolve each monomer. Examples of the solvent include solvents described later as the solvent (E).

The obtained copolymer may be used directly in the form of a solution after reaction. Alternatively, a solution obtained by concentrating or diluting the solution after reaction may be used, or a solid (powder) taken out from the solution after reaction by a method such as reprecipitation may be used. In particular, the solution after reaction can be used directly in the preparation of the colored resin composition by using a solvent contained in the colored resin composition as the solvent for the polymerization, whereby the producing process of the colored resin composition can be simplified.

The ratio of the structural unit derived from each of (a) to (c) in the total structural units constituting the resin [K2] is preferably the following:

the structural unit derived from (a): 2 to 45 mol%;
the structural unit derived from (b): 2 to 95 mol%; and
the structural unit derived from (c): 1 to 65 mol%,

and more preferably the following:

the structural unit derived from (a): 5 to 40 mol%;
the structural unit derived from (b): 5 to 80 mol%; and
the structural unit derived from (c): 5 to 60 mol%.

When the ratio of the structural unit of the resin [K2] falls within the above-mentioned range, there is a tendency that the storage stability of the colored resin composition, the developability thereof during the formation of a colored pattern, and the solvent resistance, heat resistance, and mechanical strength of an optical filter to be produced are excellent.

The resin [K2] can be produced in a similar manner to the producing method of the resin [K1], for example.

The ratio of the structural unit derived from each of (a) and (c) in the total structural units constituting the resin [K3] is preferably the following:

the structural unit derived from (a): 2 to 60 mol%; and
the structural unit derived from (c): 40 to 98 mol%,

and more preferably the following:

the structural unit derived from (a): 10 to 50 mol%; and
the structural unit derived from (c): 50 to 90 mol%.

The resin [K3] can be produced in a similar manner to the producing method of the resin [K1], for example.

The resin [K4] can be produced by producing a copolymer of (a) and (c) and then adding a cyclic ether having 2 to 4 carbon atoms contained in (b) to a carboxylic acid and/or a carboxylic anhydride contained in (a).

First, the copolymer of (a) and (c) is produced in a similar manner to the producing method of the resin [K1]. In this case, the ratio of the structural unit derived from each of (a) and (c) is preferably the same ratio as that described in the resin [K3].

Next, a cyclic ether having 2 to 4 carbon atoms contained in (b) is reacted with a part of the carboxylic acid and/or the carboxylic anhydride derived from (a) in the copolymer.

Subsequent to the production of the copolymer of (a) and (c), atmosphere in the flask is replaced from a nitrogen to air, and (b), a reaction catalyst for a carboxylic acid or a carboxylic anhydride and a cyclic ether (for example, tris(dimethylaminomethyl)phenol), and a polymerization inhibitor (for example, hydroquinone) are placed in the flask, followed by reacting, for example, at 60 to 130°C for 1 to 10 hours, whereby the resin [K4] can be produced.

The amount of (b) used is preferably 5 to 80 mol, and more preferably 10 to 75 mol, relative to 100 mol of (a). When the amount of (b) used falls within the above-mentioned range, there is a tendency that the storage stability of

the colored resin composition, the developability thereof during the formation of a pattern, and the balance of the solvent resistance, heat resistance, mechanical strength, and sensitivity of the pattern obtained are good. Since the reactivity of the cyclic ether is high, and the unreacted (b) is less likely to remain, (b) used for the resin [K4] is preferably (b1), and more preferably (b1-1).

The amount of the reaction catalyst used is preferably 0.001 to 5 parts by mass relative to 100 parts by mass of the total amount of (a), (b), and (c). The amount of the polymerization inhibitor used is preferably 0.001 to 5 parts by mass relative to 100 parts by mass of the total amount of (a), (b), and (c).

Reaction conditions such as a feeding method, a reaction temperature, and time can be appropriately adjusted in consideration of a production equipment, an amount of heat generation due to polymerization, and the like. In consideration of the production equipment, the amount of heat generation due to polymerization, and the like, the feeding method and the reaction temperature can be appropriately adjusted like the polymerization conditions.

A producing method of the resin [K5] contains a step of producing a copolymer of (b) and (c) in a similar manner to the producing method of the resin [K1] as a first step. In the same manner as in the above, the obtained copolymer may be used directly in the form of a solution after reaction. Alternatively, a solution obtained by concentrating or diluting the solution after reaction may be used, or a solid (powder) taken out from the solution after reaction by a method such as reprecipitation may be used.

The ratio of the structural unit derived from each of (b) and (c) relative to the total number of moles of the total structural units constituting the copolymer is preferably the following:

the structural unit derived from (b): 5 to 95 mol%; and
the structural unit derived from (c): 5 to 95 mol%,

and more preferably the following:

the structural unit derived from (b): 10 to 90 mol%; and
the structural unit derived from (c): 10 to 90 mol%.

The producing method of the resin [K5] further contains a step of reacting a carboxylic acid or a carboxylic anhydride contained in (a) with the cyclic ether derived from (b) contained in the copolymer of (b) and (c) under the same conditions as those of the producing method of the resin [K4], whereby the resin [K5] can be produced.

The amount of (a) used that is reacted with the copolymer is preferably 5 to 80 mol relative to 100 mol of (b). Since the reactivity of the cyclic ether is high, and the unreacted (b) is less likely to remain, (b) used for the resin [K5] is preferably (b1), and more preferably (b1-1).

The resin [K6] is a resin produced by further reacting a carboxylic anhydride with the resin [K5]. The carboxylic anhydride is reacted with a hydroxy group generated by the reaction between the cyclic ether and the carboxylic acid or a carboxylic anhydride.

Examples of the carboxylic anhydride include maleic anhydride, citraconic anhydride, itaconic anhydride, 3-vinylphthalic anhydride, 4-vinylphthalic anhydride, 3,4,5,6-tetrahydrophthalic anhydride, 1,2,3,6-tetrahydrophthalic anhydride, dimethyltetrahydrophthalic anhydride, and 5,6-dicarboxybicyclo[2.2.1]hept-2-ene anhydride. The amount of the carboxylic anhydride used is preferably 0.5 to 1 mol relative to 1 mol of the amount of (a) used.

Specific examples of the resin (B) include a resin [K1] such as a 3,4-epoxycyclohexylmethyl(meth)acrylate/(meth)acrylic acid copolymer or a 3,4-epoxytricyclo[5.2.1.0$^{2,6}$]decyl acrylate/(meth)acrylic acid copolymer; a resin [K2] such as a 3,4-epoxytricyclo[5.2.1.0$^{2,6}$]decyl acrylate/benzyl(meth)acrylate/(meth)acrylic acid copolymer, a glycidyl(meth)acrylate/benzyl(meth)acrylate/(meth)acrylic acid copolymer, a glycidyl(meth)acrylate/styrene/(meth)acrylic acid copolymer, a 3,4-epoxytricyclo[5.2.1.0$^{2,6}$]decyl acrylate/(meth)acrylic acid/N-cyclohexylmaleimide copolymer, a 3,4-epoxytricyclo[5.2.1.0$^{2,6}$]decyl acrylate/(meth)acrylic acid/N-cyclohexylmaleimide/2-hydroxyethyl(meth)acrylate copolymer, or a 3-methyl-3-(meth)acryloyloxymethyl oxetane/(meth)acrylic acid/styrene copolymer; a resin [K3] such as a benzyl(meth)acrylate/(meth)acrylic acid copolymer or a styrene/(meth)acrylic acid copolymer; a resin [K4] such as a resin produced by adding glycidyl(meth)acrylate to a benzyl(meth)acrylate/(meth)acrylic acid copolymer, a resin produced by adding glycidyl(meth)acrylate to a tricyclodecyl(meth)acrylate/styrene/(meth)acrylic acid copolymer, or a resin produced by adding glycidyl(meth)acrylate to a tricyclodecyl(meth)acrylate/benzyl(meth)acrylate/(meth)acrylic acid copolymer; a resin [K5] such as a resin produced by reacting a tricyclodecyl(meth)acrylate/glycidyl(meth)acrylate copolymer with (meth)acrylic acid, or a resin produced by reacting a tricyclodecyl(meth)acrylate/styrene/glycidyl(meth)acrylate copolymer with (meth)acrylic acid; and a resin [K6] such as a resin produced by reacting a tricyclodecyl(meth)acrylate/glycidyl(meth)acrylate copolymer with (meth)acrylic acid to produce a resin and then reacting this resin with a tetrahydrophthalic anhydride.

The resin (B) is preferably a copolymer having a structural unit derived from at least one selected from the group consisting of an unsaturated carboxylic acid and an unsaturated carboxylic anhydride and a structural unit having

a cyclic ether structure having 2 to 4 carbon atoms and an ethylenically unsaturated bond (the resin [K1] or the resin [K2]), and more preferably the resin [K2].

The weight average molecular weight of the resin (B) in terms of polystyrene is preferably 500 to 100,000, more preferably 700 to 50,000, and still more preferably 900 to 30,000. When the molecular weight falls within the above-mentioned range, there is a tendency that the hardness of the optical filter is improved, that the residual film ratio is increased, that the solubility of an unexposed area by a developing solution becomes good, and that the resolution of a colored pattern is improved.

The degree of dispersion [weight average molecular weight (Mw)/number average molecular weight (Mn)] of the resin (B) is preferably 1.1 to 6, and more preferably 1.2 to 4.

The acid value of the resin (B) is preferably 50 to 170 mg-KOH/g, more preferably 60 to 150 mg-KOH/g, and still more preferably 70 to 135 mg-KOH/g, in terms of solid content. The acid value is a value which is measured as an amount (mg) of potassium hydroxide required for neutralizing 1 g of the resin (B), and which can be determined by, for example, titration with an aqueous potassium hydroxide solution.

The content of the resin (B) is preferably 7 to 80% by mass, more preferably 13 to 75% by mass, and still more preferably 17 to 70% by mass, relative to the whole amount of the solid content. When the content of the resin (B) falls within the above-mentioned range, there is a tendency that the colored pattern can be formed, and that the resolution of the colored pattern and the residual film ratio are improved.

<Polymerizable Compound (C)>

The polymerizable compound (C) is a compound capable of being polymerized by the action of an active radical and/or an acid generated from the polymerization initiator (D). Examples of the polymerizable compound (C) include a compound having a polymerizable ethylenically unsaturated bond, and a (meth)acrylic acid ester compound is preferable.

Among these, the polymerizable compound (C) is preferably a polymerizable compound having three or more ethylenically unsaturated bonds. Examples of such a polymerizable compound include trimethylolpropane tri(meth)acrylate, pentaerythritol tri(meth)acrylate, pentaerythritol tetra(meth)acrylate, dipentaerythritol penta(meth)acrylate, dipentaerythritol hexa(meth)acrylate, tripentaerythritol octa(meth)acrylate, tripentaerythritol hepta(meth)acrylate, tetrapentaerythritol deca(meth)acrylate, tetrapentaerythritol nona(meth)acrylate, tris(2-(meth)acryloyloxyethyl)isocyanurate, ethylene glycol-modified pentaerythritol tetra(meth)acrylate, ethylene glycol-modified dipentaerythritol hexa(meth)acrylate, propylene glycol-modified pentaerythritol tetra(meth)acrylate, propylene glycol-modified dipentaerythritol hexa(meth)acrylate, caprolactone-modified pentaerythritol tetra(meth)acrylate, and caprolactone-modified dipentaerythritol hexa(meth)acrylate.

Among these, the polymerizable compound (C) preferably contains at least one selected from the group consisting of trimethylolpropane tri(meth)acrylate, dipentaerythritol penta(meth)acrylate, and dipentaerythritol hexa(meth)acrylate.

The weight average molecular weight of the polymerizable compound (C) is preferably 150 or more and 2,900 or less, and more preferably 250 or more and 1,500 or less.

The content of the polymerizable compound (C) is preferably 7 to 65% by mass, more preferably 13 to 60% by mass, and still more preferably 17 to 55% by mass, relative to the whole amount of the solid content. When the content of the polymerizable compound (C) falls within the above-mentioned range, there is a tendency that the residual film ratio during the formation of the colored pattern and the chemical resistance of the optical filter are improved.

<Polymerization Initiator (D)>

The polymerization initiator (D) is not particularly limited, as long as the polymerization initiator (D) is a compound capable of generating active radicals, an acid or the like by the action of light or heat to initiate polymerization. Any known polymerization initiator can be used. Examples of the polymerization initiator capable of generating active radicals include an alkylphenone compound, a triazine compound, an acylphosphine oxide compound, an O-acyloxime compound, and a biimidazole compound.

The O-acyloxime compound is a compound having a partial structure represented by formula (d1). Hereinafter, * represents a point of attachment.

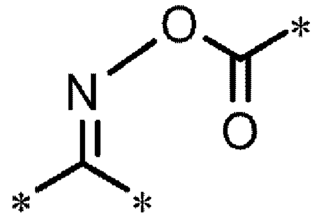

(d1)

Examples of the O-acyloxime compound include N-benzoyloxy-1-(4-phenylsulfanylphenyl)butane-1-one-2-imine, N-benzoyloxy-1-(4-phenylsulfanylphenyl)octane-1-one-2-imine, N-benzoyloxy-1-(4-phenylsulfanylphenyl)-3-cyclopentylpropane-1-one-2-imine, N-acetoxy-1-[9-ethyl-6-(2-methylbenzoyl)-9H-carbazole-3-yl]ethane-1-imine, N-acetoxy-1-[9-ethyl-6-{2-methyl-4-(3,3-dimethyl-2,4-dioxacyclopentanylmethyloxy)benzoyl}-9H-carbazole-3-yl]ethane-1-imine, N-acetoxy-1-[9-ethyl-6-(2-methylbenzoyl)-9H-carbazole-3-yl]-3-cyclopentylpropane-1-imine, N-benzoyloxy-1-[9-ethyl-6-(2-methylbenzoyl)-9H-carbazole-3-yl]-3-cyclopentylpropane-1-one-2-imine, and N-acetyloxy-1-(4-phenylsulfanylphenyl)-3-cyclohexylpropane-1-one-2-imine. Commercially available products such as Irgacure OXE01 and OXE02 (all manufactured by BASF Corporation), and N-1919 (manufactured by ADEKA Corporation) may be used. Among these, the O-acyloxime compound is preferably at least one selected from the group consisting of N-acetyloxy-1-(4-phenylsulfanylphenyl)-3-cyclohexylpropane-1-one-2-imine, N-benzoyloxy-1-(4-phenylsulfanylphenyl)butane-1-one-2-imine, N-benzoyloxy-1-(4-phenylsulfanylphenyl)octane-1-one-2-imine, and N-benzoyloxy-1-(4-phenylsulfanylphenyl)-3-cyclopentylpropane-1-one-2-imine; and more preferably N-acetyloxy-1-(4-phenylsulfanylphenyl)-3-cyclohexylpropane-1-one-2-imine, and N-benzoyloxy-1-(4-phenylsulfanylphenyl)octane-1-one-2-imine. There is a tendency that these O-acyloxime compounds provide an optical filter having a high brightness.

The alkylphenone compound is a compound having a partial structure represented by formula (d2) or (d3). In these partial structures, the benzene ring optionally has a substituent.

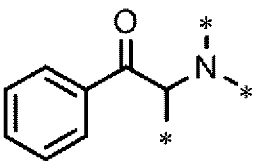

(d2)

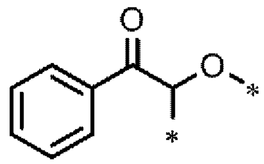

(d3)

Examples of the compound having a partial structure represented by formula (d2) include 2-methyl-2-morpholino-1-(4-methylsulfanylphenyl)propane-1-one, 2-dimethylamino-1-(4-morpholinophenyl)-2-benzylbutane-1-one, and 2-(dimethylamino)-2-[(4-methylphenyl)methyl] -1- [4-(4-morpholinyl)phenyl]butane-1-one. Commercially available products such as Irgacures 369, 907, and 379 (all manufactured by BASF Corporation) may be used.

Examples of the compound having a partial structure represented by formula (d3) include 2-hydroxy-2-methyl-1-phenylpropane-1-one, 2-hydroxy-2-methyl-1-[4-(2-hydroxyethoxy)phenyl]propane-1-one, 1-hydroxycyclohexylphenylketone, an oligomer of 2-hydroxy-2-methyl-1-(4-isopropenylphenyl)propane-1-one, $\alpha,\alpha$-diethoxyacetophenone, and benzyl dimethyl ketal.

The alkylphenone compound is preferably a compound having a partial structure represented by formula (d2) from the viewpoint of sensitivity

Examples of the triazine compound include 2,4-bis(trichloromethyl)-6-(4-methoxyphenyl)-1,3,5-triazine, 2,4-bis(trichloromethyl)-6-(4-methoxynaphthyl)-1,3,5-triazine, 2,4-bis(trichloromethyl)-6-piperonyl-1,3,5-triazine, 2,4-bis(trichloromethyl)-6-(4-methoxystyryl)-1,3,5-triazine, 2,4-bis(trichloromethyl)-6-[2-(5-methylfuran-2-yl)ethenyl]-1,3,5-triazine, 2,4-bis(trichloromethyl)-6-[2-(furan-2-yl)ethenyl]-1,3,5-triazine, 2,4-bis(trichloromethyl)-6-[2-(4-diethylamino-2-methylphenyl)ethenyl]-1,3,5-triazine, and 2,4-bis(trichloromethyl)-6-[2-(3,4-dimethoxyphenyl)ethenyl]-1,3,5-triazine.

Examples of the acylphosphine oxide compound include 2,4,6-trimethylbenzoyldiphenylphosphine oxide. Commercially available products such as Irgacure (registered trademark) 819 (manufactured by BASF Corporation) may be used.

Examples of the biimidazole compound include 2,2'-bis(2-chlorophenyl)-4,4',5,5'-tetraphenylbiimidazole, 2,2'-bis(2,3-dichlorophenyl)-4,4',5,5'-tetraphenylbiimidazole (for example, see Japanese Patent Laid-Open No. H6-75372 and Japanese Patent Laid-Open No. H6-75373), 2,2'-bis(2-chlorophenyl)-4,4',5,5'-tetraphenyl biimidazole, 2,2'-bis(2-chlorophenyl)-4,4',5,5'-tetra(alkoxyphenyl)biimidazole, 2,2'-bis(2-chlorophenyl)-4,4',5,5'-tetra(dialkoxyphenyl)biimidazole, 2,2'-bis(2-chlorophenyl)-4,4',5,5'-tetra(trialkoxyphenyl)biimidazole (for example, see Japanese Patent Publication No. S48-38403 and Japanese Patent Laid-Open No. S62-174204), and a biimidazole compound in which a phenyl group at the 4,4'5,5' position is substituted with a carboalkoxy group (for example, see Japanese Patent Laid-Open No. H7-10913).

Furthermore, examples of the polymerization initiator (D) include benzoin compounds such as benzoin, benzoin methyl ether, benzoin ethyl ether, benzoin isopropyl ether, and benzoin isobutyl ether; benzophenone compounds such as benzophenone, methyl o-benzoylbenzoate, 4-phenylbenzophenone, 4-benzoyl-4'-methyldiphenyl sulfide, 3,3',4,4'-tetra(tert-butylperoxycarbonyl)benzophenone, and 2,4,6-trimethylbenzophenone; quinone compounds such as 9,10-phenanthrene quinone, 2-ethylanthraquinone, and camphorquinone; 10-butyl-2-chloroacridone, benzyl, methyl phenylglyoxylate, and a titanocene compound. These are preferably used in combination with a polymerization initiation aid (D1) (particularly, amines) to be described later.

Examples of a polymerization initiator that generates an acid include onium salts such as 4-hydroxyphenyldimethylsulfonium p-toluenesulfonate, 4-hydroxyphenyldimethylsulfoniumhexafluoroantimonate, 4-acetoxyphenyldimethylsulfonium p-toluenesulfonate, 4-acetoxyphenylmethylbenzylsulfoniumhexafluoroantimonate, triphenylsulfonium p-toluenesulfonate, triphenylsulfonium hexafluoroantimonate, diphenyliodonium p-toluenesulfonate, and diphenyliodoniumhexafluoroantimonate; nitrobenzyl tosylates; and benzoin tosylates.

The polymerization initiator (D) is preferably a polymerization initiator containing at least one selected from the group consisting of an alkylphenone compound, a triazine compound, an acylphosphine oxide compound, an O-acyloxime compound, and a biimidazole compound, and more preferably a polymerization initiator containing an O-acyloxime compound.

The content of the polymerization initiator (D) is preferably 0.1 to 30 parts by mass, and more preferably 1 to 20 parts by mass, relative to 100 parts by mass of the total amount of the resin (B) and the polymerizable compound (C). When the content of the polymerization initiator (D) falls within the above-mentioned range, there is a tendency that the sensitivity is increased and the time of exposure to light is shortened, resulting in the improvement in productivity of the optical filter.

<Polymerization Initiation Aid (D1)>

The polymerization initiation aid (D1) is a compound to be used for accelerating polymerization of a polymerizable compound, the polymerization of which has been started by the polymerization initiator, or a sensitizer. When the polymerization initiation aid (D1) is contained, it is usually used in combination with the polymerization initiator (D).

Examples of the polymerization initiation aid (D1) include an amine compound, an alkoxyanthracene compound, a thioxanthone compound, and a carboxylic acid compound.

Examples of the amine compound include triethanolamine, methyldiethanolamine, triisopropanolamine, methyl 4-dimethylaminobenzoate, ethyl 4-dimethylaminobenzoate, isoamyl 4-dimethylaminobenzoate, 2-dimethylaminoethyl benzoate, 2-ethylhexyl 4-dimethylaminobenzoate, N,N-dimethylparatoluidine, 4,4'-bis(dimethylamino)benzophenone (common name: Michler's ketone), 4,4'-bis(diethylamino)benzophenone, and 4,4'-bis(ethylmethylamino)benzophenone. Among these, 4,4'-bis(diethylamino)benzophenone is preferable. Commercially available products such as EAB-F (manufactured by Hodogaya Chemical Co., Ltd.) may be used.

Examples of the alkoxyanthracene compound include 9,10-dimethoxyanthracene, 2-ethyl-9,10-dimethoxyanthracene, 9,10-diethoxyanthracene, 2-ethyl-9,10-diethoxyanthracene, 9,10-dibutoxyanthracene, and 2-ethyl-9,10-dibutoxyanthracene.

Examples of the thioxanthone compound include 2-isopropylthioxanthone, 4-isopropylthioxanthone, 2,4-diethylthioxanthone, 2,4-dichlorothioxanthone, and 1-chloro-4-propoxythioxanthone.

Examples of the carboxylic acid compound include phenylsulfanylacetic acid, methylphenylsulfanylacetic acid, ethylphenylsulfanylacetic acid, methylethylphenylsulfanylacetic acid, dimethylphenylsulfanylacetic acid, methoxyphenysulfanylacetic acid, dimethoxyphenylsulfanylacetic acid, chlorophenylsulfanylacetic acid, dichlorophenylsulfanylacetic acid, N-phenylglycine, phenoxyacetic acid, naphthylthioacetic acid, N-naphthylglycine, and naphthoxyacetic acid.

When the polymerization initiation aid (D1) is used, the content thereof is preferably 0.1 to 30 parts by mass, and more preferably 1 to 20 parts by mass, relative to 100 parts by mass of the total amount of the resin (B) and the polymerizable compound (C). When the amount of the polymerization initiation aid (D1) falls within the above-mentioned range, there is a tendency that the colored pattern can be formed with higher sensitivity, resulting in the improvement in productivity of the optical filter.

<Solvent (E)>

The solvent (E) is not particularly limited, and any solvent that has been used conventionally in the art can be used. Examples of the solvent (E) include an ester solvent (a solvent that contains -COO- but does not contain -O- in its molecule), an ether solvent (a solvent that contains -O- but does not contain -COO- in its molecule), an ether ester solvent (a solvent that contains -COO- and -O- in its molecule), a ketone solvent (a solvent that contains -CO- but does not contain -COO- in its molecule), an alcohol solvent (a solvent that contains OH but does not contain -O-, -CO- nor -COO- in its molecule), an aromatic hydrocarbon solvent, an amide solvent, and dimethyl sulfoxide.

Examples of the ester solvent include methyl lactate, ethyl lactate, butyl lactate, methyl 2-hydroxy isobutanoate, ethyl acetate, n-butyl acetate, isobutyl acetate, pentyl formate, isopentyl acetate, butyl propionate, isopropyl butyrate, ethyl butyrate, butyl butyrate, methyl pyruvate, ethyl pyruvate, propyl pyruvate, methyl acetoacetate, ethyl acetoacetate, cyclohexanol acetate, and γ-butyrolactone.

Examples of the ether solvent include ethylene glycol monomethyl ether, ethylene glycol monoethyl ether, ethylene glycol monopropyl ether, ethylene glycol monobutyl ether, diethylene glycol monomethyl ether, diethylene glycol monoethyl ether, diethylene glycol monobutyl ether, propylene glycol monomethyl ether, propylene glycol monoethyl ether, propylene glycol monopropyl ether, propylene glycol monobutyl ether, 3-methoxy-1-butanol, 3-methoxy-3-methylbutanol, tetrahydrofuran, tetrahydropyran, 1,4-dioxane, diethylene glycol dimethyl ether, diethylene glycol diethyl ether, diethylene glycol methyl ethyl ether, diethylene glycol dipropyl ether, diethylene glycol dibutyl ether, anisole, phenetol, and methyl anisole.

Examples of the ether ester solvent include methyl methoxyacetate, ethyl methoxyacetate, butyl methoxyacetate, methyl ethoxyacetate, ethyl ethoxyacetate, methyl 3-methoxypropionate, ethyl 3-methoxypropionate, methyl 3-ethoxypropionate, ethyl 3-ethoxypropionate, methyl 2-methoxypropionate, ethyl 2-methoxypropionate, propyl 2-methoxypropionate, methyl 2-ethoxy propionate, ethyl 2-ethoxypropionate, methyl 2-methoxy-2-methylpropionate, ethyl 2-ethoxy-2-methylpropionate, 3-methoxybutyl acetate, 3-methyl-3-methoxybutyl acetate, propylene glycol monomethyl ether acetate, propylene glycol monoethyl ether acetate, propylene glycol monopropyl ether acetate, ethylene glycol monomethyl ether acetate, ethylene glycol monoethyl ether acetate, diethylene glycol monoethyl ether acetate, and diethylene glycol monobutyl ether acetate.

Examples of the ketone solvent include 4-hydroxy-4-methyl-2-pentanone, acetone, 2-butanone, 2-heptanone, 3-heptanone, 4-heptanone, 4-methyl-2-pentanone, cyclopentanone, cyclohexanone, and isophorone.

Examples of the alcohol solvent include methanol, ethanol, propanol, butanol, hexanol, cyclohexanol, ethylene glycol, propylene glycol, and glycerin.

Examples of the aromatic hydrocarbon solvent include benzene, toluene, xylene, and mesitylene.

Examples of the amide solvent include N,N-dimethylformamide, N,N-dimethylacetamide, and N-methylpyrrolidone.

The solvent is preferably one or more selected from the group consisting of an ether solvent, an ether ester solvent, and an amide solvent, more preferably at least one selected from the group consisting of an ether solvent, an ether ester solvent, and an amide solvent, and still more preferably at least one selected from the group consisting of diethylene glycol methylethyl ether, propylene glycol monomethyl ether acetate, and N-methylpyrrolidone.

The content of the solvent (E) is preferably 70 to 95% by mass, and more preferably 75 to 92% by mass, relative to the whole amount of the colored resin composition. In other words, the solid content of the colored resin composition is preferably 5 to 30% by mass, and more preferably 8 to 25% by mass. When the content of the solvent (E) falls within the above-mentioned range, there is a tendency that the flatness during application becomes good and the color density of the optical filter formed becomes not insufficient, resulting in the achievement of good displaying properties.

<Leveling Agent (F)>

Examples of the leveling agent (F) include a silicone-based surfactant, a fluorine-based surfactant, and a silicone-based surfactant having a fluorine atom. These may have a polymerizable group at its side chain.

Examples of the silicone-based surfactant include a surfactant having a siloxane bond in its molecule. Specific examples thereof include Toray Silicone DC3PA, Toray Silicone SH7PA, Toray Silicone DC11PA, Toray Silicone SH21PA, Toray Silicone SH28PA, Toray Silicone SH29PA, Toray Silicone SH30PA, and Toray Silicone SH8400 (trade name; manufactured by Toray Dow Corning Co., Ltd.); KP321, KP322, KP323, KP324, KP326, KP340, and KP341 (manufactured by Shin-Etsu Chemical Co., Ltd.); and TSF400, TSF401, TSF410, TSF4300, TSF4440, TSF4445, TSF4446, TSF4452, and TSF4460 (manufactured by Momentive Performance Materials Inc.).

Examples of the fluorine-based surfactant include a surfactant having a fluorocarbon chain in its molecule. Specific examples thereof include Fluorad (registered trademark) FC430 and Fluorad FC431 (manufactured by Sumitomo 3M, Ltd.); Megafac (registered trademark) F142D, Megafac F171, Megafac F172, Megafac F173, Megafac F177, Megafac F183, Megafac F554, Megafac R30, and Megafac RS-718-K (manufactured by DIC Corporation); Eftop (registered trademark) EF301, Eftop EF303, Eftop EF351, and Eftop EF352 (manufactured by Mitsubishi Materials Electronic Chemicals Co., Ltd.); Surflon (registered trademark) S381, Surflon S382, Surflon SC101, and Surflon SC105 (manufactured by AGC Inc. (former Asahi Glass Co., Ltd.)); and E5844 (manufactured by Daikin Fine Chemical Laboratory).

Examples of the silicone-based surfactant having a fluorine atom include a surfactant having a siloxane bond and a fluorocarbon chain in its molecule. Specific examples thereof include Megafac (registered trademark) R08, Megafac BL20, Megafac F475, Megafac F477, and Megafac F443 (manufactured by DIC Corporation).

The content of the leveling agent (F) is preferably 0.001 to 0.2% by mass, more preferably 0.002 to 0.1% by mass, and still more preferably 0.005 to 0.05% by mass, relative to the whole amount of the colored resin composition.

This content does not include the content of the pigment dispersant. When the content of the leveling agent (F) falls within the above-mentioned range, the flatness of the optical filter can be improved.

<Other Components>

If required, the colored resin composition may contain an additive known in the art, such as a filler, other polymeric compounds, an adhesion promoter, an antioxidant, a light stabilizer, or a chain transfer agent.

<Method for Producing Colored Resin Composition>

The colored resin composition can be prepared by, for example, mixing compounds represented by formula (I) and/or formula (II) and a resin (B), as well as a polymerizable compound (C), a polymerization initiator (D), a solvent (E), a leveling agent (F), a polymerization initiation aid (D1), and other components to be used if necessary.

The compound represented by formula (I) or formula (II) may be contained in advance in a pigment dispersion. By mixing the pigment dispersion with the remaining ingredients so as to obtain a predetermined concentration, an intended colored resin composition can be prepared.

When the colored resin composition contains a dye, the dye may be dissolved in advance in a part or the whole of the solvent (E) to prepare a solution. The solution is preferably filtered with a filter having a pore size of about 0.01 to 1 μm.

The colored resin composition after mixing is preferably filtered with a filter having a pore size of about 0.01 to 10 μm.

[Color Filter]

Examples of the method for producing a colored pattern of a color filter from the colored resin composition of the present invention include a photolithography method, an inkjet method, and a printing method. Among these methods, a photolithography method is preferable. The photolithography method is a method in which the colored resin composition is applied onto a substrate and then dried to form a composition layer, and the composition layer is then developed by exposing the composition layer to light through a photomask. In the photolithography method, a colored coating film, which is a cured material of the composition layer, can be formed when the photomask is not used during the exposure to light and/or the composition layer is not developed.

The film thickness of the color filter (cured film) is, for example, 30 μm or less, preferably 20 μm or less, more preferably 6 μm or less, still more preferably 3 μm or less, still further preferably 1.5 μm or less, and particularly preferably 0.5 μm or less; and preferably 0.1 μm or more, more preferably 0.2 μm or more, and still more preferably 0.3 μm or more.

Examples of the substrate to be used include glass substrates such as quartz glass, borosilicate glass, alumina silicate glass, and soda lime glass of which the surface is coated with silica; resin substrates such as polycarbonate, polymethyl methacrylate, and polyethylene terephthalate; silicon; and a substrate obtained by forming an aluminum, silver, or a silver/copper/palladium alloy thin film or the like on any of the aforementioned substrates. On such a substrate, another color filter layer, a resin layer, a transistor, a circuit and the like may be formed. A substrate obtained by subjecting a silicon substrate to HMDS treatment may also be used.

The formation of each color pixel by a photolithography method can be carried out using a known or conventional device under known or conventional conditions. For example, the color pixel can be prepared in the following manner. First, a colored resin composition is applied onto a substrate, and then dried by heat-drying (prebaking) and/or drying under reduced pressure to remove volatile components such as a solvent from the composition, thereby producing a smooth composition layer. Examples of the application method include a spin coat method, a slit coat method, and a slit-and-spin coat method. The temperature at heat-drying is preferably 30 to 120°C, and more preferably 50 to 110°C. The time for the heating is preferably 10 seconds to 60 minutes, and more preferably 30 seconds to 30 minutes. When drying under reduced pressure is carried out, the drying procedure is preferably carried out at a temperature range of 20 to 25°C under a pressure of 50 to 150 Pa. The film thickness of the composition layer is not particularly limited, and may be selected appropriately depending on the desired film thickness of the color filter.

Next, the composition layer is exposed to light through a photomask for forming a desired colored pattern. The pattern on the photomask is not particularly limited, and a pattern suitable for the intended application is used. A light source to be used for the exposure to light is preferably a light source capable of generating light having a wavelength of 250 to 450 nm. For example, light having a wavelength of shorter than 350 nm may be cut with a filter capable of cutting light having this wavelength region, or light having a wavelength of around 436 nm, around 408 nm, or around 365 nm may be extracted selectively with a band-pass filter capable of extracting light having those wavelength regions. Specific examples of the light source include a mercury lamp, a light-emitting diode, a metal halide lamp, and a halogen lamp. A reduction projection exposure apparatus such as a mask aligner and a stepper, or a proximity exposure apparatus

is preferably used because these apparatuses are capable of emitting a parallel light beam uniformly over the whole area of the exposed surface or accurately aligning the photomask to the substrate.

A colored pattern is formed on the substrate by bringing the exposed composition layer into contact with a developing solution to develop the composition layer. By developing, an unexposed area in the composition layer is dissolved in the developing solution and therefore removed. The developing solution is preferably an aqueous solution of an alkaline compound such as potassium hydroxide, sodium hydrogen carbonate, sodium carbonate, or tetramethylammonium hydroxide. The concentration of the alkaline compound in the aqueous solution is preferably 0.01 to 10% by mass, and more preferably 0.03 to 5% by mass. The developing solution may further contain a surfactant. The developing method may be any of a paddle method, a dipping method, a spray method, and the like. Furthermore, during the developing process, the substrate may be inclined at any angle.

After the developing process, the resultant product is preferably washed with water.

Furthermore, the resultant colored pattern is preferably subjected to post-baking. The temperature for the post-baking is preferably 80 to 250°C, and more preferably 100 to 245°C. The time for the post-baking is preferably 1 to 120 minutes, and more preferably 2 to 30 minutes.

The colored pattern and the colored coating film thus produced are useful as a color filter. The color filter is useful as a color filter used for a display devices such as a liquid crystal display device or an organic EL device; an electronic paper; a solid-state image sensor; and the like.

This application claims benefit of priority based on Japanese Patent No. 2020-147098 filed on September 1, 2020. The entire content of the specification of Japanese Patent No. 2020-147098 filed on September 1, 2020 is incorporated herein by reference.

## EXAMPLES

Hereinafter, the present invention will be described in more detail with reference to Examples. However, of course, the present invention is not limited to the following Examples, and various design variations made in accordance with the purports described hereinbefore and hereinafter are also included in the technical scope of the present invention. In the Examples, the terms "%" and "parts" that represent a content or an amount used are based on mass unless otherwise specified.

The structures of compounds were identified by mass spectrometry (LC: Model 1200 manufactured by Agilent Technologies, Inc., MASS: Model LC/MSD manufactured by Agilent Technologies, Inc.).

### Example 1

1.0 part of a compound represented by formula (1) (manufactured by Tokyo Chemical Industry Co., Ltd.), 0.41 parts of a compound represented by formula (2) (manufactured by FUJIFILM Wako Pure Chemical Corporation), 0.18 parts of triethylamine (manufactured by Tokyo Chemical Industry Co., Ltd.), and 5.0 parts of N-methylpyrrolidone (NMP) (manufactured by FUJIFILM Wako Pure Chemical Corporation) were mixed at room temperature, and the mixture was heated to 120°C and stirred for 6 hours. After cooling this reaction solution to room temperature, 50 parts of ion exchange water was added thereto. The resulting precipitate was collected as a suction filtration residue, washed with 50 parts of ion exchange water, and then dried under reduced pressure while heating at 60°C to produce 1.23 parts of a compound represented by formula (3). The yield was 92%.

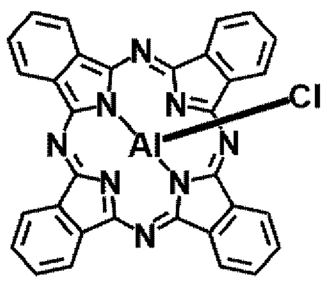
(1)

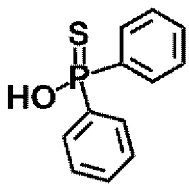
(2)

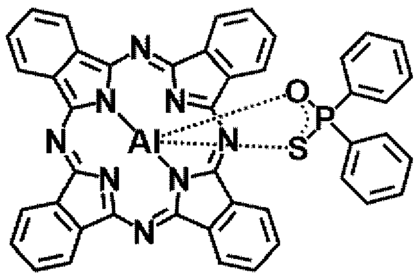

(3)

Identification of compound represented by formula (3)
(Mass spectrometry)

Ionization mode = ESI$^+$: m/z = $[M+H]^+$ 773.2
Exact Mass: 772.2

Comparative Example 1

A compound represented by formula (4) was produced by the synthesis method described in Japanese Patent Laid-Open No. 2016-75837.

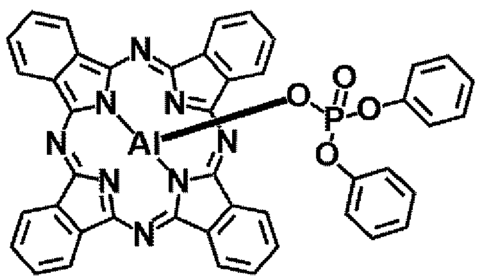

(4)

Resin Synthesis Example 1

A proper amount of nitrogen was passed into a flask equipped with a reflux condenser, a dropping funnel, and a stirrer to replace the atmosphere with nitrogen. Then, 340 parts of propylene glycol monomethyl ether acetate was added into the flask, and then heated to 80°C while stirring. Subsequently, a mixed solution containing 57 parts of acrylic acid, 54 parts of a mixture of 3,4-epoxytricyclo[5.2.1.$0^{2,6}$]decan-8-ylacrylate and 3,4-epoxytricyclo[5.2.1.$0^{2,6}$]decan-9-ylacrylate (the content ratio was 1:1 by mole), 239 parts of benzyl methacrylate, and 73 parts of propylene glycol monomethyl ether acetate was added dropwise into the flask over 5 hours. Meanwhile, a solution prepared by dissolving 40 parts of a polymerization initiator, 2,2-azobis(2,4-dimethylvaleronitrile), in 197 parts of propylene glycol monomethyl ether acetate was added dropwise over 6 hours. After the completion of the dropwise addition of the polymerization initiator-containing solution, the solution was retained at 80°C for 3 hours, and then cooled to room temperature to obtain a copolymer (resin (B-1)) solution having a viscosity of 137 mPa·s as measured at 23°C with a Type-B viscometer and a solid content of 36.8% by weight. The produced copolymer had a weight average molecular weight of $1.0 \times 10^3$ in terms of polystyrene, a degree of dispersion of 1.97, and an acid value of 111 mg-KOH/g in terms of solid content. The resin (B-1) has the following structural units.

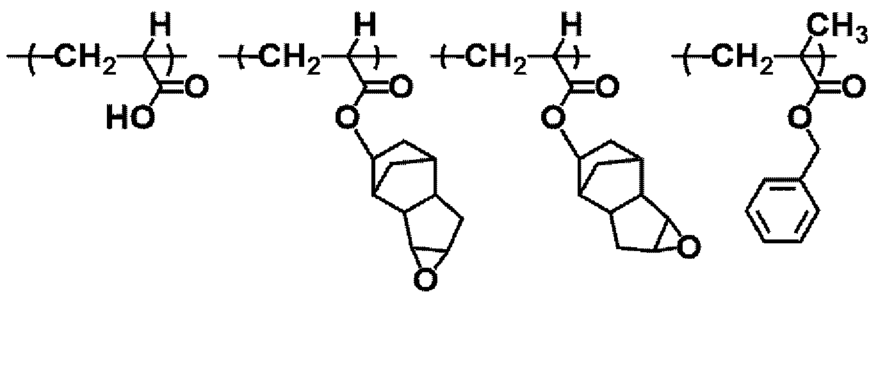

Dispersion Preparation Example 1

5 parts of the compound represented by formula (3) produced in Example 1, 4 parts of a dispersant (BYKLPN-6919 manufactured by BYK) (in terms of solid content), 4 parts of the resin (B-1) (in terms of solid content), and 87 parts of propylene glycol monomethyl ether acetate were mixed, 300 parts of 0.2 μm zirconia beads were added thereto, and this mixture was shaken for 1 hour using a paint conditioner (manufactured by LAU). Subsequently, the zirconia beads were removed by filtration to prepare a dispersion (A-1).

Dispersion Preparation Example 2

5 parts of the compound represented by formula (4) produced in Comparative Example 1, 8 parts of a dispersant (BYKLPN-6919 manufactured by BYK) (in terms of solid content), 8 parts of the resin (B-1) (in terms of solid content), and 79 parts of propylene glycol monomethyl ether acetate were mixed, 300 parts of 0.2 μm zirconia beads were added thereto, and this mixture was shaken for 1 hour using a paint conditioner (manufactured by LAU). Subsequently, the zirconia beads were removed by filtration to prepare a dispersion (A-2).

[Preparation of Colored Resin Composition 1]

A colored resin composition 1 was prepared by mixing the following components.

Dispersion (A-1): 432 parts
Resin (B-1): 43 parts (in terms of solid content)
Polymerizable compound (C-1): Dipentaerythritol polyacrylate: trade name A-9550, manufactured by Shin-Nakamura Chemical Co., Ltd.: 20 parts
Polymerizable compound (C-2): Trimethylolpropane triacrylate: trade name A-TMPT, manufactured by Shin-Nakamura Chemical Co., Ltd.: 20 parts
Polymerization initiator (D): N-acetyloxy-1-(4-phenylsulfanylphenyl)-3-cyclohexylpropane-1-one-2-imine: trade name PBG-327: O-acyloxime compound, manufactured by Changzhou Tronly New Electronic Materials Co., Ltd.): 5.0 parts
Solvent (E): Propylene glycol monomethyl ether acetate: 680 parts
Leveling agent (F): Polyether modified silicone oil (trade name Toray silicone SH8400, manufactured by Toray Dow Corning Co., Ltd.): 0.1 parts

[Preparation of Comparative Colored Resin Composition 1]

A comparative colored resin composition 1 was prepared by mixing the following components.

Dispersion (A-2): 517 parts
Resin (B-1): 19 parts (in terms of solid content)
Polymerizable compound (C-1): Dipentaerythritol polyacrylate: trade name A-9550, manufactured by Shin-Nakamura Chemical Co., Ltd.: 20 parts
Polymerizable compound (C-2): Trimethylolpropane triacrylate: trade name A-TMPT, manufactured by Shin-Nakamura Chemical Co., Ltd.: 20 parts
Polymerization initiator (D): N-acetyloxy-1-(4-phenylsulfanylphenyl)-3-cyclohexylpropane-1-one-2-imine: trade name PBG-327: O-acyloxime compound, manufactured by Changzhou Tronly New Electronic Materials Co., Ltd.): 5.0 parts
Solvent (E): Propylene glycol monomethyl ether acetate: 855 parts
Leveling agent (F): Polyether modified silicone oil (trade name Toray silicone SH8400, manufactured by Toray Dow Corning Co., Ltd.): 0.1 parts

[Formation of Colored Coating Film]

Each of the colored resin compositions prepared in the preparation of the colored resin composition 1 and the comparative colored resin composition 1 was applied onto a 5-cm square glass substrate (Eagle 2000, manufactured by Corning Incorporated) by a spin coating method, and then prebaked at 100°C for 3 minutes to form a colored coating film.

[Color Change Before and After Post-Baking of Colored Coating Film]

The colored coating film after prebaking was subjected to spectrometry with a colorimeter (OSP-SP-200; manufactured by Olympus Corporation), and xy chromaticity coordinates (x, y) and stimulus value Y in the CIE-XYZ color system were measured using the characteristic function for a C light source. In addition, the transmittance of the colored coating film after prebaking was measured.

Then, the colored coating film after prebaking was post-baked at 230°C for 10 minutes.

For the colored coating film after post-baking, xy chromaticity coordinates (x, y) and stimulus value Y were measured in the same manner as above. The color difference ΔEab was calculated from the measurement values before and after post-baking. A smaller ΔEab value means a smaller change in color. The results are shown in Table 11.

In addition, the transmittance of the colored coating film after post-baking was measured. When the transmittance before post-baking and the transmittance after post-baking at a certain wavelength λ were taken as $X_\lambda$ and Yx, respectively, the amounts of changes in transmittance were calculated based on the following formula at intervals of 5 nm in the wavelength of 500 to 650 nm.

$$\text{The amounts of changes in transmittance (\%)} = |(1 - Y_\lambda/X_\lambda) \times 100|$$

The average value of the obtained values was defined as "Change rate of transmittance in 500 to 650 nm". The results are shown in Table 11.

[Table 11]

| | ⊿ Eab | Change rate of transmittance in 500 to 650 nm |
|---|---|---|
| Colored resin composition 1 | 2.1 | 10% |
| Comparative colored resin composition 1 | 7.9 | 19% |

**Claims**

1. A compound represented by formula (I) or formula (II):

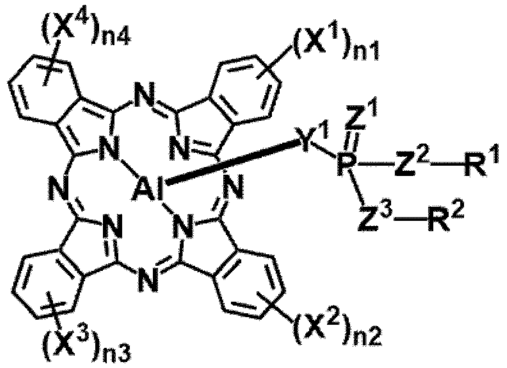

(I)

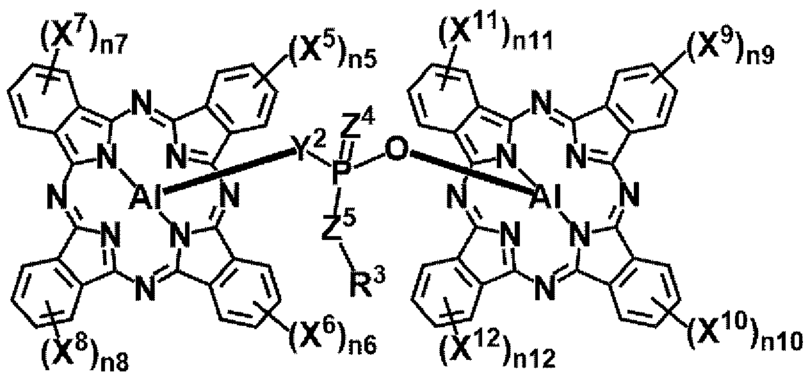

(II)

wherein in the formula (I),

$R^1$ represents a hydrogen atom or a hydrocarbon group having 1 to 20 carbon atoms and optionally having a substituent;
$R^2$ represents a hydrogen atom, a hydrocarbon group having 1 to 20 carbon atoms and optionally having a substituent, or a single bond connecting $Z^3$ and $R^1$;
$Y^1$ and $Z^1$ each independently represent an oxygen atom or a sulfur atom, and $Z^2$ and $Z^3$ each independently represent a single bond, an oxygen atom, or a sulfur atom, provided that at least one of $Y^1$, $Z^1$, $Z^2$, and $Z^3$ represents a sulfur atom;
$X^1$ to $X^4$ each independently represent $-R^4$, $-OR^4$, $-SR^4$, a halogen atom, a nitro group, or a sulfamoyl group optionally having a substituent;
$R^4$ represents a hydrocarbon group having 1 to 20 carbon atoms and optionally having a substituent; and
n1 to n4 each independently represent an integer of 0 to 4, and
in the formula (II),
$R^3$ represents a hydrogen atom or a hydrocarbon group having 1 to 20 carbon atoms and optionally having a substituent;
$Y^2$ and $Z^4$ each independently represent an oxygen atom or a sulfur atom, and $Z^5$ represents a single bond, an oxygen atom, or a sulfur atom, provided that at least one of $Y^2$, $Z^4$, and $Z^5$ represents a sulfur atom;
$X^5$ to $X^{12}$ each independently represent $-R^5$, $-OR^5$, $-SR^5$, a halogen atom, a nitro group, or a sulfamoyl group optionally having a substituent;
$R^5$ represents a hydrocarbon group having 1 to 20 carbon atoms and optionally having a substituent; and
n5 to n12 each independently represent an integer of 0 to 4.

**2.** A colored resin composition comprising the compound according to claim 1 and a resin.

**3.** The colored resin composition according to claim 2, comprising a polymerizable compound and a polymerization initiator.

**4.** A color filter formed from the colored resin composition according to claim 2 or 3.

**5.** A display device comprising the color filter according to claim 4.

## INTERNATIONAL SEARCH REPORT

International application No. **PCT/JP2021/030239**

**A. CLASSIFICATION OF SUBJECT MATTER**

***C09B 47/08***(2006.01)i; ***C09D 4/00***(2006.01)i; ***G03F 7/004***(2006.01)i; ***G02B 5/20***(2006.01)i; ***C09D 7/41***(2018.01)i; ***C09B 67/20***(2006.01)i
FI: C09B47/08 CSP; C09B67/20 G; C09D7/41; C09D4/00; G03F7/004 505; G02B5/20 101

According to International Patent Classification (IPC) or to both national classification and IPC

**B. FIELDS SEARCHED**

Minimum documentation searched (classification system followed by classification symbols)

C09B47/08; C09D4/00; G03F7/004; G02B5/20; C09D7/41; C09B67/20

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

CAplus/REGISTRY (STN)

**C. DOCUMENTS CONSIDERED TO BE RELEVANT**

| Category* | Citation of document, with indication, where appropriate, of the relevant passages | Relevant to claim No. |
|---|---|---|
| A | JP 04-214388 A (TOYO INK MFG CO LTD) 05 August 1992 (1992-08-05) entire text | 1-5 |
| A | WO 2019/022051 A1 (DIC CORPORATION) 31 January 2019 (2019-01-31) entire text | 1-5 |
| A | JP 2013-182021 A (TOYO INK SC HOLDINGS CO LTD) 12 September 2013 (2013-09-12) entire text | 1-5 |

☐ Further documents are listed in the continuation of Box C.
☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **21 October 2021** | **02 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | Telephone No. |

Form PCT/ISA/210 (second sheet) (January 2015)

**INTERNATIONAL SEARCH REPORT**
**Information on patent family members**

International application No.
**PCT/JP2021/030239**

| Patent document cited in search report | Publication date (day/month/year) | Patent family member(s) | Publication date (day/month/year) |
|---|---|---|---|
| JP 04-214388 A | 05 August 1992 | (Family: none) | |
| WO 2019/022051 A1 | 31 January 2019 | TW 201920496 A | |
| JP 2013-182021 A | 12 September 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2016075837 A
- JP 2010032999 A
- JP 4492760 B
- JP H675372 A
- JP H675373 A
- JP S4838403 A
- JP S62174204 A
- JP H710913 A
- JP 2020147098 A


### Non-patent literature cited in the description


- Color Index. The Society of Dyers and Colourists